# EUROPEAN PATENT APPLICATION

(11) **EP 4 836 658 A1**
(43) Date of publication of application: **04.11.2026**
(21) Application number: 26169780.9
(22) Date of filing: 31.03.2026
(51) Int. Cl.: H10K 59/80, H10K 59/40

(54) **DISPLAY MODULE, ELECTRONIC DEVICE INCLUDING THE SAME, AND METHOD OF MANUFACTURING THE DISPLAY MODULE**

(30) Priority: 28.04.2025 KR 20250055566
(71) Applicant: Samsung Display Co., Ltd., Yongin-si, Gyeonggi-do 17113 (KR)
(72) Inventor: PARK, Heeyeon, Yongin-si, Gyeonggi-Do (KR); KOO, Jinyoung, Yongin-si, Gyeonggi-Do (KR); KIM, Yeonguk, Yongin-si, Gyeonggi-Do (KR); SONG, Changyeong, Yongin-si, Gyeonggi-Do (KR); YANG, Gihoon, Yongin-si, Gyeonggi-Do (KR); YU, Sanghee, Yongin-si, Gyeonggi-Do (KR); LEE, Hyungwoo, Yongin-si, Gyeonggi-Do (KR); JUNG, Hyein, Yongin-si, Gyeonggi-Do (KR); JU, Yongchan, Yongin-si, Gyeonggi-Do (KR); HA, Jaeheung, Yongin-si, Gyeonggi-Do (KR)
(74) Representative: Gulde & Partner

(57) **Abstract**

A display module includes a display element layer including a pixel definition layer through which a pixel opening is defined and a light emitting element, and an encapsulation layer on the display element layer. The encapsulation layer includes a first inorganic encapsulation layer on the display element layer, an organic encapsulation layer on the first inorganic encapsulation layer, and a second inorganic encapsulation layer on the organic encapsulation layer. The organic encapsulation layer includes an organic material represented by any one selected from the following chemical formulas 1 to 3.

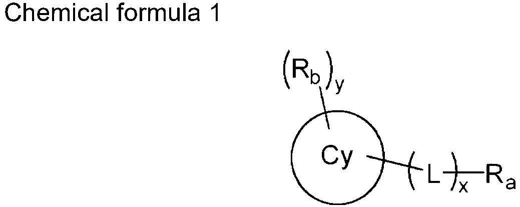

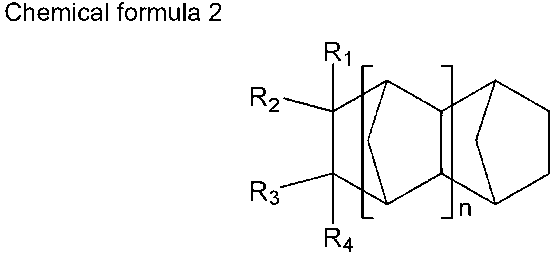

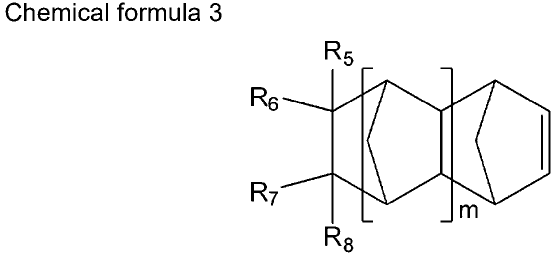

## Description

### BACKGROUND

### 1. Field

Embodiments of the present disclosure relate to a display module, an electronic device including the same, and a method of manufacturing the display module. For example, embodiments of the present disclosure relate to a display module and an electronic device having improved durability and enhanced sensing performance of an input sensor on a display element layer.

### 2. Description of Related Art

An electronic device includes an active area that is activated in response to electrical signals. The electronic device senses inputs applied from the outside through the active area and simultaneously displays various images to provide information to a user.

The electronic device includes a light emitting element to which an organic light emitting material or a quantum dot light emitting material is applied. The light emitting element is vulnerable to external environments such as oxygen and moisture, and therefore, various technologies to encapsulate the light emitting element are needed. Among the technologies, an encapsulation layer that is on the light emitting element to block infiltration paths of air and moisture is being developed. However, when an input sensor layer such as a touch panel is provided on the encapsulation layer, the encapsulation layer causes a decrease in touch sensitivity or malfunctions.

### SUMMARY

The invention is defined by the appended claims. The description that follows is subject to this limitation. Any disclosure lying outside the scope of said claims is only intended for illustrative as well as comparative purposes.

Embodiments of the present disclosure provide a display module having improved durability and enhanced sensing performance of an input sensor on a display element layer and an electronic device including the display module.

Embodiments of the present disclosure provide a method of manufacturing the display module having improved durability and sensing performance.

Embodiments of the present disclosure provide a display module including a display element layer including a pixel definition layer through which a pixel opening is defined and a light emitting element and an encapsulation layer on the display element layer. The encapsulation layer includes a first inorganic encapsulation layer on the display element layer, an organic encapsulation layer on the first inorganic encapsulation layer, and a second inorganic encapsulation layer on the organic encapsulation layer. The organic encapsulation layer includes an organic material represented by any one selected from the following chemical formulas 1 to 3, 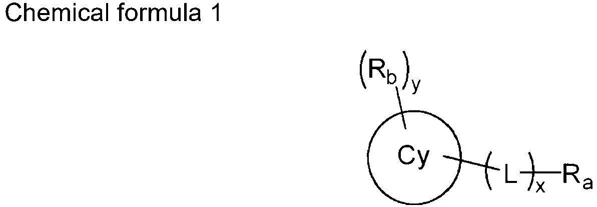 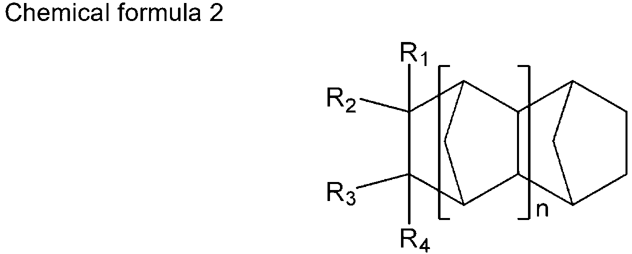 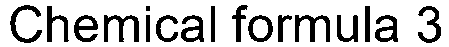 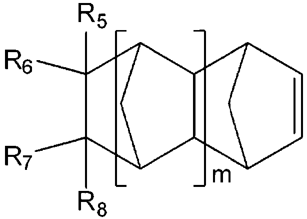 where, in chemical formulas 1 to 3, Cy is a norbornane ring or a norbornene ring, L is a direct linkage, a substituted or unsubstituted alkylene group having 1 to 20 carbon atoms, a substituted or unsubstituted alkyleneoxy group having 1 to 20 carbon atoms, or a substituted or unsubstituted aryleneoxy group having 6 to 30 ring-forming carbon atoms, Rₐ is a substituted or unsubstituted siloxane group, a substituted or unsubstituted cyclosiloxane group, a substituted or unsubstituted norbornane ring, a substituted or unsubstituted norbornene ring, or a substituted or unsubstituted alkyl group having 1 to 20 carbon atoms, or is bonded with a neighboring group to form a ring, R_{b} is a hydrogen atom, a deuterium atom, a halogen atom, a substituted or unsubstituted siloxane group, a substituted or unsubstituted cyclosiloxane group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or is bonded with a neighboring group to form a ring, x is an integer from 1 to 10, y is an integer from 0 to 11 if (e.g., when) Cy is the norbornane ring, y is an integer from 0 to 9 if (e.g., when) Cy is the norbornene ring, R₁ to R₈ are each independently a hydrogen atom, a deuterium atom, a halogen atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or are bonded with a neighboring group to form the ring, and n and m are each independently an integer from 0 to 20.

The organic encapsulation layer has a dielectric constant greater than or equal to about 2.1 and smaller than or equal to about 2.83.

The organic encapsulation layer is directly on the first inorganic encapsulation layer, and the second inorganic encapsulation layer is directly on the organic encapsulation layer.

The organic encapsulation layer has a refractive index greater than or equal to about 1.4 and smaller than or equal to about 1.6.

The organic encapsulation layer has a hardness from 0.01 GPa to 0.2 GPa and a modulus from 0.01 GPa to 4 GPa.

The organic encapsulation layer has a thickness greater than or equal to about 3 micrometers and smaller than or equal to about 13 micrometers.

Each of the first inorganic encapsulation layer and the second inorganic encapsulation layer includes at least one selected from silicon nitride, silicon oxide, and silicon oxynitride.

The chemical formula 1 is represented by any one selected from the following chemical formulas 1-1 to 1-5, 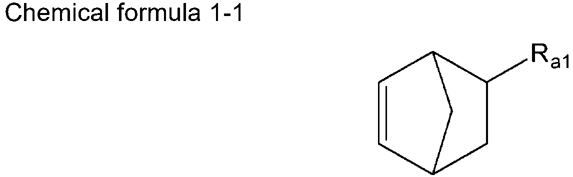 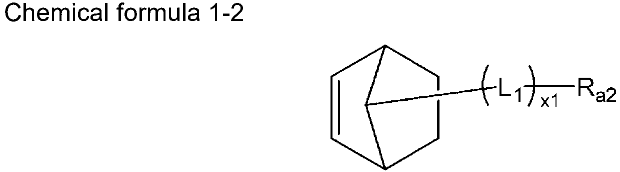 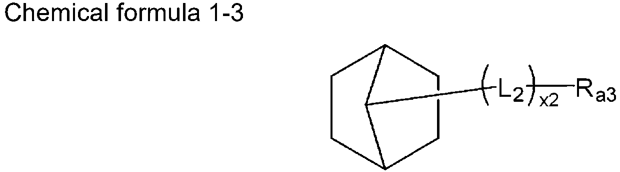 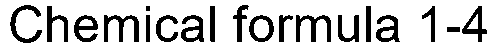 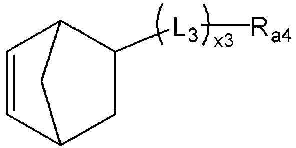 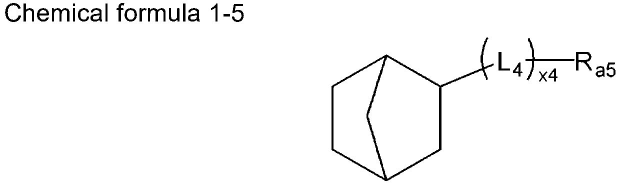 where, in chemical formulas 1-1 to 1-5, Rₐ₁ is a substituted or unsubstituted alkyl group having 1 to 10 carbon atoms, Rₐ₂ to Rₐ₅ are each independently a substituted or unsubstituted norbornane ring, a substituted or unsubstituted norbornene ring, a siloxane group represented by the following chemical formula A, or a cyclosiloxane group represented by the following chemical formula B, L₁ to L₄ are each independently a direct linkage, a substituted or unsubstituted alkylene group having 1 to 20 carbon atoms, or a substituted or unsubstituted alkyleneoxy group having 1 to 20 carbon atoms, x₁ to x₄ are each independently an integer from 1 to 10, and 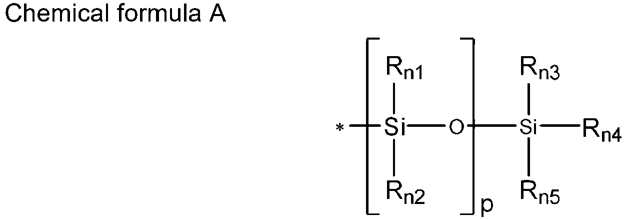 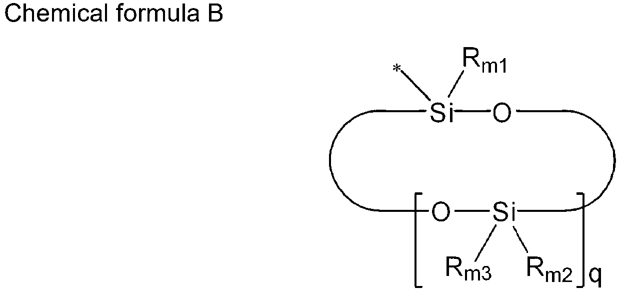 where, in chemical formulas A and B, Rₙ₁ to Rₙ₅ and Rₘ₁ to Rₘ₃ are each independently an alkoxy group having 1 to 20 carbon atoms, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, p is an integer from 1 to 20, and q is an integer from 1 to 5.

The display module further includes an input sensor on the encapsulation layer, the encapsulation layer is directly on the light emitting element, and the input sensor is directly on the encapsulation layer.

The encapsulation layer covers the light emitting element.

The light emitting element includes a first electrode exposed through the pixel opening, a second electrode on the first electrode, and a light emitting layer between the first electrode and the second electrode.

The light emitting element further includes a hole control layer between the first electrode and the light emitting layer and an electron control layer between the light emitting layer and the second electrode.

An upper surface of the second inorganic encapsulation layer defines an uppermost surface of the encapsulation layer.

Embodiments of the present disclosure provide an electronic device including a display module including a display panel and an input sensor on the display panel and a power module that supplies a power to the display module. The display panel includes a display element layer including a pixel definition layer through which a pixel opening is defined and a light emitting element and an encapsulation layer on the display element layer. The encapsulation layer includes a first inorganic encapsulation layer on the display element layer, an organic encapsulation layer on the first inorganic encapsulation layer, and a second inorganic encapsulation layer on the organic encapsulation layer. The organic encapsulation layer includes an organic material represented by any one selected from the above chemical formulas 1 to 3.

The input sensor includes a first sensor insulating layer (e.g., a first sensor electrically insulating layer) directly on the second inorganic encapsulation layer, a first sensor conductive layer on the first sensor insulating layer, a second sensor insulating layer (e.g., a second sensor electrically insulating layer) on the first sensor insulating layer and covering the first sensor conductive layer, and a second sensor conductive layer on the second sensor insulating layer.

The electronic device further includes at least one selected from a processor, and a memory.

Embodiments of the present disclosure provide a method of manufacturing a display module. The manufacturing method includes forming a display element layer including a pixel definition layer and a light emitting element and forming an encapsulation layer on the display element layer to cover the light emitting element. The forming of the encapsulation layer includes forming a first inorganic encapsulation layer on the display element layer, providing an encapsulation composition on the first inorganic encapsulation layer to form an organic encapsulation layer, and forming a second inorganic encapsulation layer on the organic encapsulation layer. The encapsulation composition is represented by any one selected from the above chemical formulas 1 to 3.

The encapsulation composition further includes a photoinitiator and a crosslinker, and, based on 100 wt% of a total content of the encapsulation composition, the encapsulation composition includes the organic material in an amount in a range from about 60 wt% to about 80 wt%, the photoinitiator in an amount in a range from about 1 wt% to about 10 wt%, and the crosslinker in an amount in a range from about 20 wt% to about 40 wt%.

The forming of the organic encapsulation layer includes coating the encapsulation composition on the first inorganic encapsulation layer to form a preliminary organic encapsulation layer and irradiating a light onto the preliminary organic encapsulation layer to form the organic encapsulation layer.

According to the above, the durability of the display module is improved, and the sensing performance of the input sensor on the display element layer is also improved.

According to the above, the display module having improved durability and sensing performance is manufactured.

### BRIEF DESCRIPTION OF THE DRAWINGS

The accompanying drawings, together with the specification, illustrate embodiments of the subject matter of the present disclosure, and, together with the description, serve to explain principles of embodiments of the subject matter of the present disclosure.
FIG. 1 is a block diagram of an electronic device according to an embodiment of the present disclosure;
FIG. 2 is a schematic view illustrating electronic devices according to an embodiment of the present disclosure;
FIGS. 3A to 3C are perspective views of an electronic device according to an embodiment of the present disclosure;
FIG. 4 is an exploded perspective view of an electronic device according to an embodiment of the present disclosure;
FIG. 5 is a perspective view of an electronic device according to an embodiment of the present disclosure;
FIG. 6 is a cross-sectional view of an electronic device according to an embodiment of the present disclosure;
FIG. 7 is a cross-sectional view of a display module according to an embodiment of the present disclosure;
FIG. 8 is a plan view of a display panel according to an embodiment of the present disclosure;
FIG. 9 is an enlarged cross-sectional view of a display module according to an embodiment of the present disclosure;
FIG. 10 is an enlarged cross-sectional view of a display module according to an embodiment of the present disclosure;
FIGS. 11A and 11B are cross-sectional views of encapsulation layers according to embodiments of the present disclosure;
FIG. 12A is a flowchart illustrating a method of manufacturing a display module according to an embodiment of the present disclosure;
FIG. 12B is a flowchart illustrating some processes of the manufacturing method of the display module according to an embodiment of the present disclosure; and
FIGS. 13A to 13F are cross-sectional views illustrating some processes of the manufacturing method of the display module according to embodiments of the present disclosure.

### DETAILED DESCRIPTION

In the present disclosure, it will be understood that if (e.g., when) an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, and/or the like may be used herein to describe various elements, these elements should not be limited by these terms. These terms are only used to distinguish one element from another element. Thus, a first element discussed below could be termed a second element without departing from the teachings of the present disclosure. As an example, without departing from the scope of the present disclosure, a first component, a first part, a first region, a first layer, and a first portion are referred to as a second component, a second part, a second region, a second layer, and a second portion, respectively, and vice versa. As used herein, the singular forms, "a", "an" and "the" are intended to include the plural forms as well, unless the context clearly indicates otherwise.

Spatially relative terms, such as "below", "lower", "above", "upper" and the like, may be used herein for ease of description to describe one element or feature's relationship to another elements or features as shown in the figures.

It will be further understood that the terms "include" and/or "including", if (e.g., when) used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, a display module, an electronic device, and a method of manufacturing the display module of the present disclosure will be described with reference to the accompanying drawings.

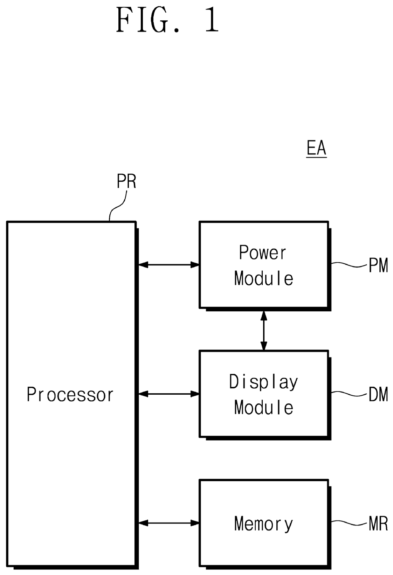

FIG. 1 is a block diagram of an electronic device according to an embodiment of the present disclosure. Referring to FIG. 1, the electronic device EA may include a display module DM, a processor PR, a memory MR, and a power module PM.

The processor PR may include at least one selected from a central processing unit (CPU), an application processor (AP), a graphics processing unit (GPU), a communication processor (CP), an image signal processor (ISP), and a controller.

The memory MR may store data information useful or required for the operation of the processor PR or the display module DM. If (e.g., when) the processor PR executes an application stored in the memory MR, an image data signal and/or an input control signal may be transmitted to the display module DM, and the display module DM may process the received signals to output image information through a display screen. The display module DM may include a display panel that displays images.

The power module PM may include a power supply module, such as a power adapter or a battery device, and a power conversion module that converts power supplied by the power supply module to generate power useful or required for the operation of the electronic device EA.

At least one of the components of the electronic device EA may be included in a display device that includes the display module according to embodiments described below. In embodiments, among individual modules that are functionally included within a single module, some may be included in the display device, while others may be provided separately from the display device. As an example, the display device may include the display module DM, and the processor PR, the memory MR, and the power module PM may be provided as separate devices within the electronic device EA rather than within the display device.

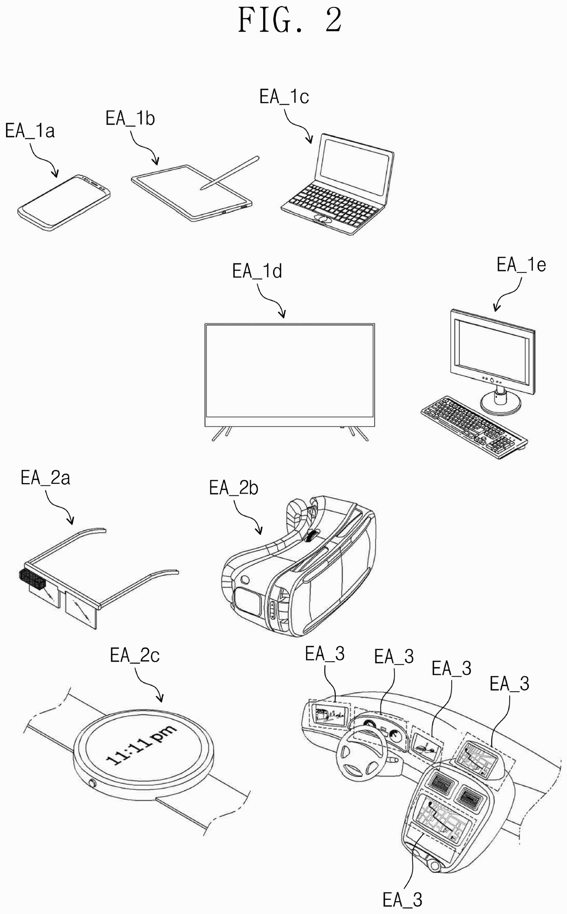

FIG. 2 is a schematic view illustrating electronic devices according to embodiments of the present disclosure.

Referring to FIG. 2, various suitable electronic devices to which a display device according to an embodiment is applied may include not only an electronic device to display images, such as a smartphone EA_1a, a tablet PC EA_1b, a laptop computer EA_1c, a television EA_1d, a desktop monitor EA_1e, and/or the like, but also a wearable electronic device, such as a smart glasses EA_2a, a head-mounted display EA_2b, a smartwatch EA_2c, and/or the like, and an in-vehicle electronic device EA_3, such as an instrument panel, a center fascia, a dashboard-mounted center information display (CID), a room mirror display, and/or the like.

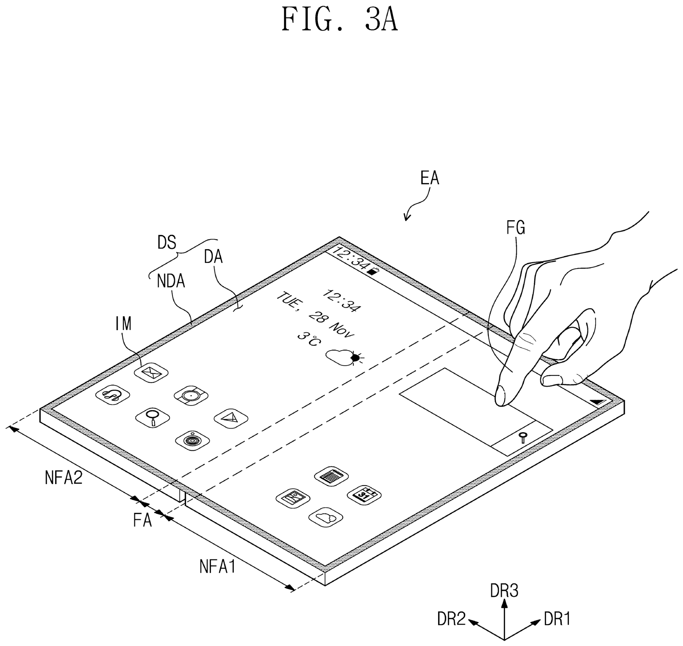

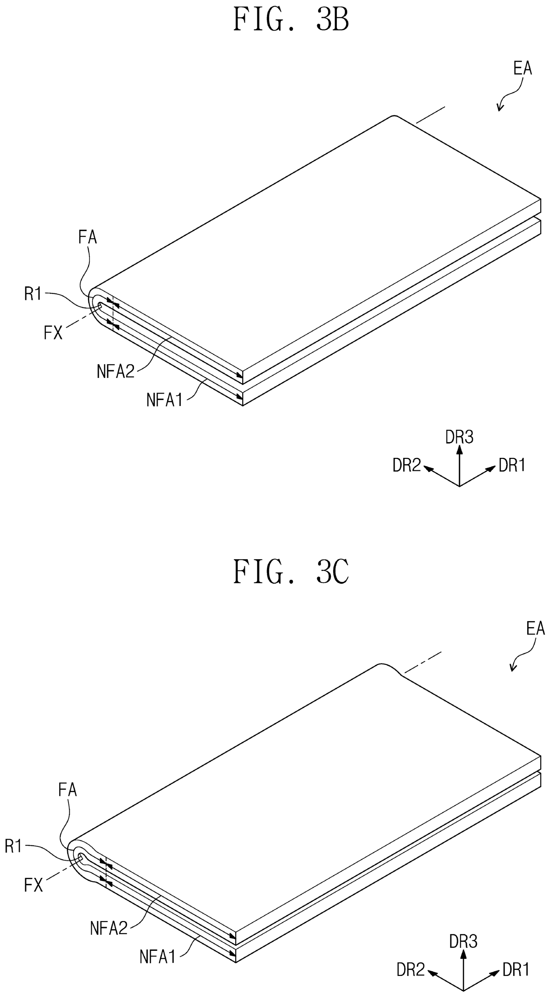

FIGS. 3A to 3C are perspective views of the electronic device EA according to an embodiment of the present disclosure. In FIGS. 3A to 3C, a smartphone is shown as a representative example of the electronic device EA. However, the description of the electronic device EA with reference to FIGS. 3A to 3C may be equally applied to other electronic devices. FIG. 3A shows an unfolded state of the electronic device EA, and FIGS. 3B and 3C show a folded state of the electronic device EA.

Referring to FIGS. 3A to 3C, the electronic device EA may include a display surface DS defined by a first direction DR1 and a second direction DR2 intersecting the first direction DR1. The electronic device EA may provide an image IM to a user through the display surface DS.

The display surface DS may include a display area DA and a non-display area NDA around the display area DA. The display area DA may display the image IM, and the non-display area NDA may not display the image IM. The non-display area NDA may surround the display area DA. However, the present disclosure should not be limited thereto or thereby, and the shape of the display area DA and the shape of the non-display area NDA may be modified.

Hereinafter, a direction substantially perpendicular to a plane defined by the first direction DR1 and the second direction DR2 may be referred to as a third direction DR3. Front and rear surfaces of each member may be distinguished from each other based on the third direction DR3. In the present disclosure, the expression "if (e.g., when) viewed in a plane" may mean a state of being viewed in the third direction DR3.

The electronic device EA may include a folding area FA and a plurality of non-folding areas NFA1 and NFA2. The non-folding areas NFA1 and NFA2 may include a first non-folding area NFA1 and a second non-folding area NFA2. The folding area FA may be between the first non-folding area NFA1 and the second non-folding area NFA2 in the second direction DR2. In the present embodiment, a foldable electronic device EA is shown as a representative example, but the present disclosure should not be limited thereto or thereby. According to an embodiment, the electronic device EA may be a bar-type, rollable, and/or slidable electronic device.

The electronic device EA may sense an input generated by a user's body part FG. A finger is shown as a representative example of the user's body part FG.

As shown in FIG. 3B, the folding area FA may be folded with respect to a folding axis FX substantially parallel to the first direction DR1. The folding area FA may have a selected curvature and a selected radius of curvature R1. The electronic device EA may be inwardly folded (inner-folding) such that the first non-folding area NFA1 and the second non-folding area NFA2 face each other and the display surface DS is not exposed to the outside.

According to an embodiment, the electronic device EA may be outwardly folded (outer-folding) such that the display surface DS is exposed to the outside. The electronic device EA may be configured to mutually repeat the inner-folding operation or the outer-folding operation from the unfolding operation, however, the present disclosure should not be limited thereto or thereby. According to an embodiment, the electronic device EA may be selectively operated in any one selected from the unfolding operation, the inner-folding operation, and the outer-folding operation.

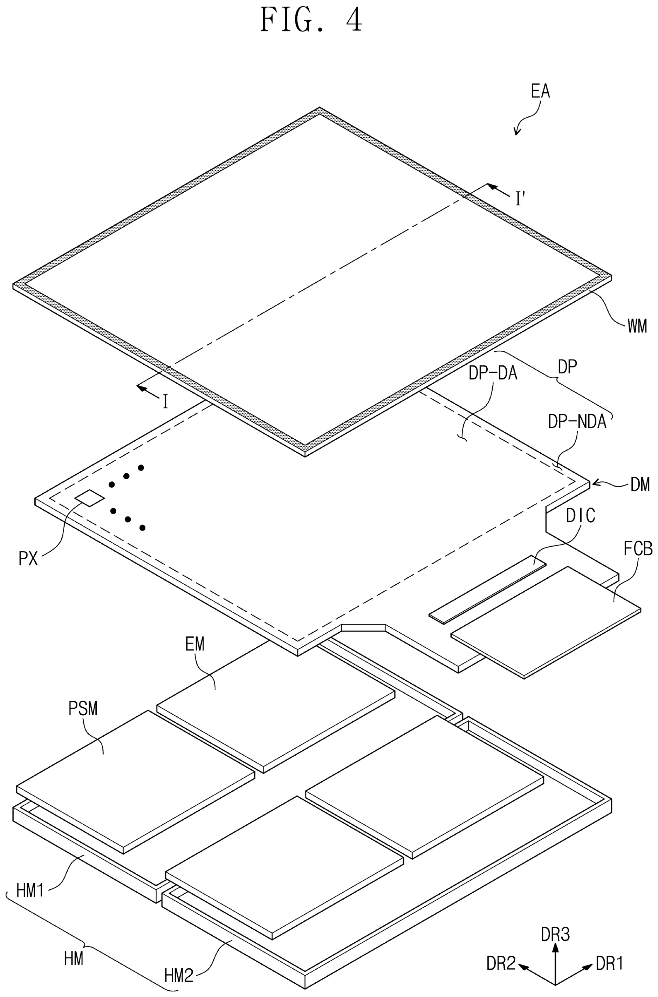

As shown in FIG. 3B, a distance between the first non-folding area NFA1 and the second non-folding area NFA2 may be substantially equal to twice the radius of curvature R1. However, as shown in FIG. 3C, the distance between the first non-folding area NFA1 and the second non-folding area NFA2 may be smaller than twice the radius of curvature R1. FIGS. 3B and 3C illustrate the electronic device EA based on the display surface DS, and portions of a housing HM (refer to FIG. 4) that forms an exterior of the electronic device EA may come into contact with each other at the ends of the first non-folding area NFA1 and the second non-folding area NFA2.

In the present disclosure, the electronic device EA applicable to a mobile phone is shown as a representative example. Electronic modules mounted on a main board, a camera module, and a power supply module may be accommodated in a bracket/case together with the electronic device EA, and thus the mobile phone may be formed. However, the present disclosure should not be limited thereto or thereby, and the electronic device EA according to embodiments of the present disclosure may be applied to a large-sized electronic item, such as a television set and a monitor, and a small and medium-sized electronic item, such as a tablet terminal, a car navigation unit, a game unit, and a smart watch.

FIG. 4 is an exploded perspective view of the electronic device EA according to an embodiment of the present disclosure.

Referring to FIG. 4, the electronic device EA may include the display module DM, an electronic module EM, a power supply module PSM, and the housing HM. In embodiments, the electronic device EA may further include a mechanical structure to control the folding operation of the electronic device EA. In FIG. 4, adhesive layers used to attach components to one another are omitted.

The electronic device EA may generate an image and may sense an external input. The electronic device EA may include a window WM and the display module DM. The window WM may provide a front surface of the electronic device EA. The electronic device EA may further include an additional component between the window WM and the display module DM or under the display module DM.

The display module DM may include at least a display panel DP. FIG. 4 shows only the display panel DP of a stack structure of the display module DM, however, the display module DM may further include a plurality of components above the display panel DP. A detailed description of the stack structure of the display module DM will be further described herein.

The display panel DP is not be particularly limited, and the display panel DP may be a light emitting type (or kind) display panel, for example, an organic light emitting display panel and/or an inorganic light emitting display panel.

The display panel DP may include a display area DP-DA and a non-display area DP-NDA, which respectively correspond to the display area DA (refer to FIG. 3A) and the non-display area NDA (refer to FIG. 3A) of the electronic device EA. Pixels PX may be arranged in the display area DP-DA. The pixels PX may not be arranged in the non-display area DP-NDA, and signal lines providing voltages to the pixels PX may be arranged in the non-display area DP-NDA. In the present disclosure, the expression "an area/portion corresponds to another area/portion" means that they overlap and is not be limited to having the same area.

As shown in FIG. 4, a driving chip DIC may be provided in the non-display area DP-NDA of the display panel DP. A flexible circuit board FCB may be coupled to the non-display area DP-NDA of the display panel DP. The flexible circuit board FCB may be connected to a main circuit board. The main circuit board may be an electronic component constituting the electronic module EM. In embodiments, the electronic module EM may further include a control module, such as an application processor, a wireless communication module, an image input module, and/or the like. Unlike the electronic device EA shown in FIG. 4, a portion of the flexible circuit board FCB may be under the display panel DP. According to an embodiment, as a portion of the display module DM and/or the flexible circuit board FCB is bent, the portion of the flexible circuit board FCB may be under the display panel DP.

The driving chip DIC may include driving elements to drive pixels PX of the display panel DP, e.g., a data driver. FIG. 4 shows a structure in which the driving chip DIC is mounted on the display panel DP, however, the present disclosure should not be limited thereto or thereby. As an example, the driving chip DIC may be mounted on the flexible circuit board FCB.

Referring to FIG. 4, the electronic module EM may be provided in each of a first housing HM1 and a second housing HM2, and the power supply module PSM may be provided in each of the first housing HM1 and the second housing HM2. In embodiments, the electronic module EM provided in the first housing HM1 and the electronic module EM provided in the second housing HM2 may be electrically connected to each other via the flexible circuit board. The housing HM may be coupled to the electronic device EA, for example, the window WM to accommodate the above-mentioned modules. Although the housing HM is shown to include the first and second housings HM1 and HM2 that are separate from each other, it should not be limited thereto or thereby. In embodiments, the electronic device EA may further include a hinge structure to connect the first and second housings HM1 and HM2.

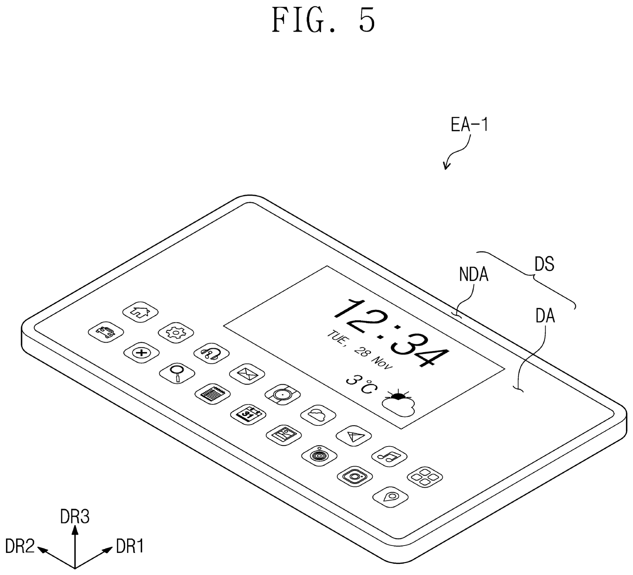

FIG. 5 is a perspective view of an electronic device EA-1 according to an embodiment of the present disclosure. Referring to FIG. 5, the electronic device EA-1 may display an image through a display surface DS. The display surface DS may have a rectangular shape defined by long sides extending in the second direction DR2 and short sides extending in the first direction DR1. However, the shape of the electronic device EA-1 should not be limited to the rectangular shape, and the electronic device EA-1 may have various suitable shapes, such as a circular shape (e.g., a generally circular shape) and a polygonal shape.

The display surface of the electronic device EA-1 according to the present embodiment may be flat, however, the present disclosure should not be limited thereto or thereby. According to an embodiment, the electronic device EA-1 may include a curved display surface or a three-dimensional display surface. The three dimensional display surface may include a plurality of display areas facing different directions from each other, and for instance, may include a bent display surface. The electronic device EA-1 according to the present embodiment may be a flexible electronic device. The electronic device EA-1 may be a foldable display device.

In the present disclosure, the electronic device EA-1 applicable to a tablet terminal is shown as a representative example. In embodiments, electronic modules mounted on a main board, a camera module, and a power supply module may be accommodated in a bracket/case together with the electronic device EA-1, and thus the tablet terminal may be formed. The electronic device EA-1 according to the present disclosure may be applied to a large-sized electronic item, such as a television set and a monitor, and a small and medium-sized electronic item, such as a mobile phone, a car navigation unit, a game unit, and a smart watch.

Referring to FIG. 5, the display surface DS may include a display area DA through which the image is displayed and a non-display area NDA defined adjacent to the display area DA. The image is not displayed through the non-display area NDA. FIG. 5 shows images of application icons as a representative example of the image.

As shown in FIG. 5, the display area DA may have a substantially quadrangular shape. The expression "substantially quadrangular shape" may mean not only a quadrangular shape mathematically defined but also a quadrangular shape in which a curved line boundary, instead of a vertex, is defined in a vertex area (or a corner area).

The non-display area NDA may surround the display area DA, however, it should not be limited thereto or thereby. The shape of the non-display area NDA may be modified. For example, the non-display area NDA may be defined only at one side of the display area DA.

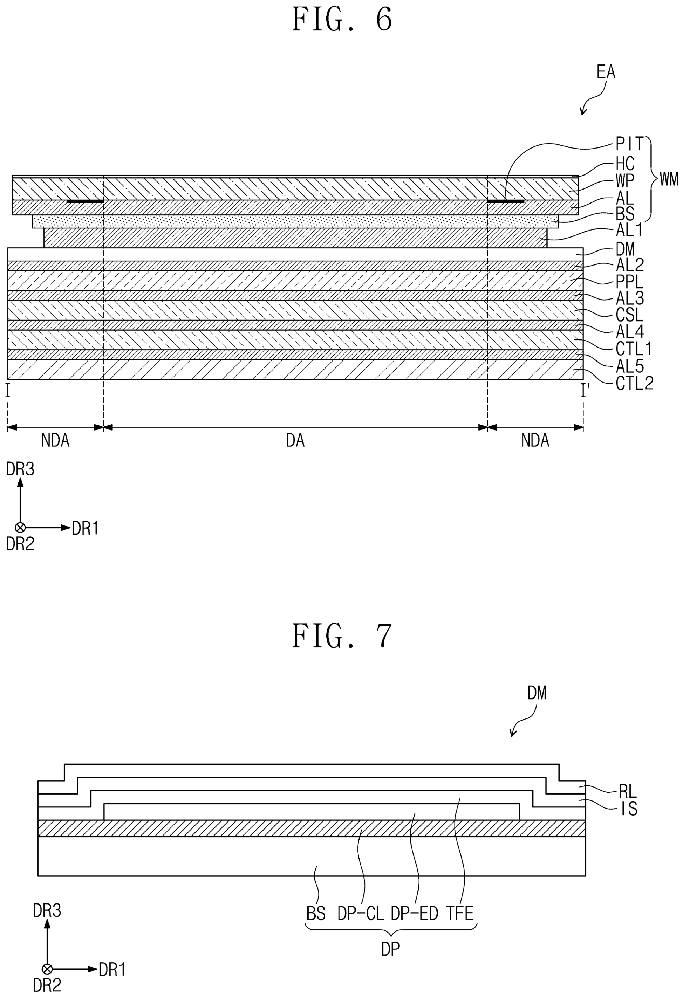

FIG. 6 is a cross-sectional view of the electronic device EA according to an embodiment of the present disclosure. FIG. 6 is a cross-sectional view of the electronic device EA taken along a line I-I' of FIG. 4.

Referring to FIG. 6, the electronic device EA may include the window WM, the display module DM, a panel protective layer PPL, a cushion layer CSL, a first lower layer CTL1, a second lower layer CTL2, and first to fifth adhesive layers AL1 to AL5. Each of the first to fifth adhesive layers AL1 to AL5 may attach two components stacked adjacent to each other among the components. The first to fifth adhesive layers AL1 to AL5 may include a pressure sensitive adhesive (PSA) and/or an optically clear adhesive (OCA), however, the type (or kind) of the adhesive layers should not be limited thereto or thereby.

The window WM may provide an outer surface of the electronic device EA. The window WM may include a base layer BS, a window protective layer WP, a hard coating layer HC, and a print layer PIT (or a black matrix layer). The base layer BS may have an optically transparent property. The base layer BS may include a glass material or a synthetic resin film. The window protective layer WP may be attached to the base layer BS by an adhesive layer AL. The window protective layer WP may include a flexible plastic material, such as polyimide (PI) and/or polyethylene terephthalate (PET). The hard coating layer HC may be on the window protective layer WP.

The print layer PIT may be on a lower surface of the window protective layer WP. The print layer PIT may be the black matrix layer. The print layer PIT may have a black color, however, a color of the print layer PIT should not be limited to the black color. The print layer PIT may be adjacent to an edge of the window protective layer WP. The print layer PIT may overlap the non-display area NDA. However, the stack structure of the window WM should not be limited to the structure described above.

The panel protective layer PPL may be under the display module DM. The panel protective layer PPL may protect a lower portion of the display module DM. The panel protective layer PPL may include a flexible plastic material. As an example, the panel protective layer PPL may include polyethylene terephthalate (PET). According to an embodiment, the panel protective layer PPL may be omitted.

The cushion layer CSL may be under the panel protective layer PPL. The cushion layer CSL may absorb external impact. The cushion layer CSL may include a foamed plastic. In an embodiment, the cushion layer CSL may be omitted.

The first lower layer CTL1 may be under the cushion layer CSL. The first lower layer CTL1 under the cushion layer CSL may protect the components thereabove from external impact. The first lower layer CTL1 may include a material having a set or certain rigidity. The first lower layer CTL1 may include, for example, a metal plate. In embodiments, the first lower layer CTL1 may include a material having high magnetic permeability. The first lower layer CTL1 may include a ferromagnetic material. For example, the first lower layer CTL1 may include a magnetic metal powder layer. The magnetic metal powder layer may include a base resin and magnetic metal powder mixed into the base resin. In an embodiment, the first lower layer CTL1 may be omitted.

The second lower layer CTL2 may be under the first lower layer CTL1. The second lower layer CTL2 may block or reduce transmission of electromagnetic waves so that electromagnetic waves generated from the electronic module EM of FIG. 4 do not interfere with the display module DM. The second lower layer CTL2 may include a diamagnetic material. In embodiments, the second lower layer CTL2 may dissipate heat generated from the display module DM, such as from a driving chip DIC (refer to FIG. 4).

The second lower layer CTL2 may include a metal layer such as copper, aluminum, gold, and/or titanium. The second lower layer CTL2 may include a metal oxide layer such as indium tin oxide (ITO) and/or indium zinc oxide (IZO). The second lower layer CTL2 may include carbon nanotubes, carbon nanotubes coated with a conductive polymer (e.g., an electrically conductive polymer), and/or graphite.

FIG. 7 is a cross-sectional view of the display module DM according to an embodiment of the present disclosure. Referring to FIG. 7, the display module DM may include the display panel DP, an input sensor IS, and an anti-reflector RL.

The display panel DP may include a base layer BS, a circuit element layer DP-CL, a display element layer DP-ED, and an encapsulation layer TFE. The base layer BS may provide a base surface on which the circuit element layer DP-CL is provided.

The base layer BS may be a rigid substrate or a flexible substrate that is bendable, foldable, and/or rollable.

The base layer BS may have a single-layer or multi-layer structure. The base layer BS may include a single resin layer or a plurality of resin layers. The base layer BS may include the plurality of resin layers and a single inorganic layer or a plurality of inorganic layers between the plurality of resin layers.

The circuit element layer DP-CL may be on the base layer BS. The circuit element layer DP-CL may include an insulating layer (e.g., an electrically insulating layer), a semiconductor pattern, a conductive pattern, and/or a signal line. The circuit element layer DP-CL may include a driving circuit of the pixel PX described with reference to FIG. 4. The display element layer DP-ED may be on the circuit element layer DP-CL. The display element layer DP-ED may include a light emitting element of the pixel PX described with reference to FIG. 4.

The encapsulation layer TFE may be on the display element layer DP-ED. The encapsulation layer TFE may protect the display element layer DP-ED from moisture, oxygen, and a foreign substance such as dust particles. The encapsulation layer TFE may include at least one inorganic layer and one organic layer. The encapsulation layer TFE may include a stack structure of inorganic and organic layers. The encapsulation layer TFE will be described in more detail herein.

The input sensor IS may be on the display panel DP. The input sensor IS may sense the input generated by the user's body part FG shown in FIG. 3A. The input sensor IS may be formed on the display panel DP through a continuous process. In embodiments, the input sensor IS may be directly on the display panel DP. The input sensor IS may be directly on the encapsulation layer TFE. The expression "a component A is directly on a component B", as used herein, means that no intervening elements are present between the component A and the component B.

The anti-reflector RL may be on the input sensor IS. The anti-reflector RL may reduce a reflectance with respect to an external light. The anti-reflector RL may be directly formed on the input sensor IS through a continuous process.

The anti-reflector RL may include color filters. The color filters may have a color corresponding to a color of a source light. For instance, a red color filter is above a light emitting element emitting a red light. The anti-reflector RL may further include a light blocking pattern between the color filters.

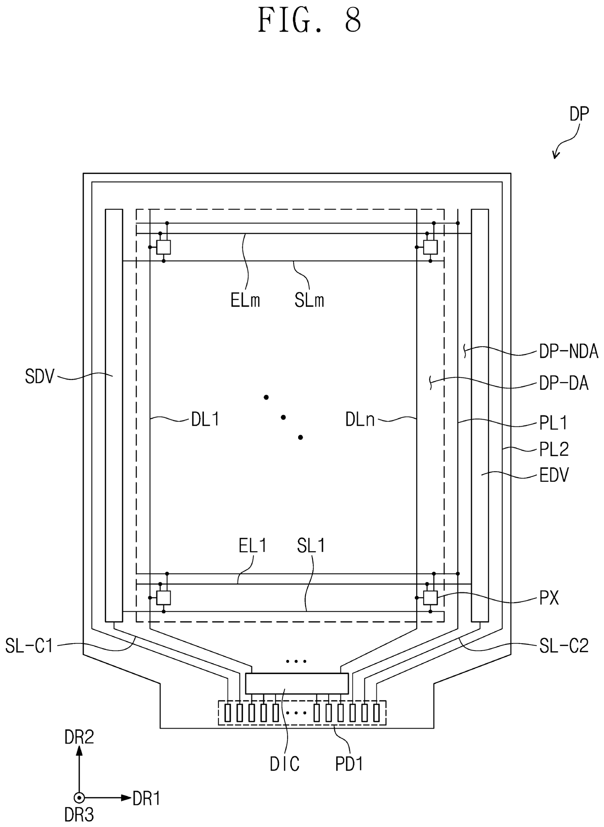

FIG. 8 is a plan view of the display panel DP according to an embodiment of the present disclosure.

Referring to FIG. 8, the display panel DP may include the pixels PX, a scan driver SDV, an emission driver EDV, a plurality of signal lines, and a plurality of first pads PD1. The driving chip DIC provided in the non-display area DP-NDA may include a data driver. The data driver may be integrated into the display panel DP like the scan driver SDV and the emission driver EDV.

The signal lines may include a plurality of scan lines SL1 to SLm, a plurality of data lines DL1 to DLn, a plurality of emission lines EL1 to ELm, a first control line SL-C1, a second control line SL-C2, a first power line PL1, and a second power line PL2. Each of the "m" and the "n" may be a natural number equal to or greater than 2.

The scan lines SL1 to SLm may extend in the first direction DR1 and may be electrically connected to the pixels PX and the scan driver SDV. The data lines DL1 to DLn may extend in the second direction DR2 and may be electrically connected to the pixels PX and the driving chip DIC. The emission lines EL1 to ELm may extend in the first direction DR1 and may be electrically connected to the pixels PX and the emission driver EDV.

The first power line PL1 may receive a first power supply voltage, and the second power line PL2 may receive a second power supply voltage having a voltage level lower than that of the first power supply voltage. In embodiments, a second electrode of the light emitting element, for instance, a cathode, may be connected to the second power line PL2.

The first control line SL-C1 may be connected to the scan driver SDV and may extend toward a lower end of the display panel DP. The second control line SL-C2 may be connected to the emission driver EDV and may extend toward the lower end of the display panel DP. The first pads PD1 may be arranged in the non-display area DP-NDA adjacent to the lower end of the display panel DP and may be closer to the lower end of the display panel DP than the driving chip DIC is. The first pads PD1 may be connected to the driving chip DIC and some of the signal lines.

The scan driver SDV may generate a plurality of scan signals, and the scan signals may be applied to the pixels PX via the scan lines SL1 to SLm. The driving chip DIC may generate a plurality of data voltages, and the data voltages may be applied to the pixels PX via the data lines DL1 to DLn. The emission driver EDV may generate a plurality of light emission signals, and the light emission signals may be applied to the pixels PX via the emission lines EL1 to ELm.

The pixels PX may receive the data voltages in response to the scan signals. The pixels PX may emit light with luminance corresponding to the data voltages in response to the light emission signals to display the image.

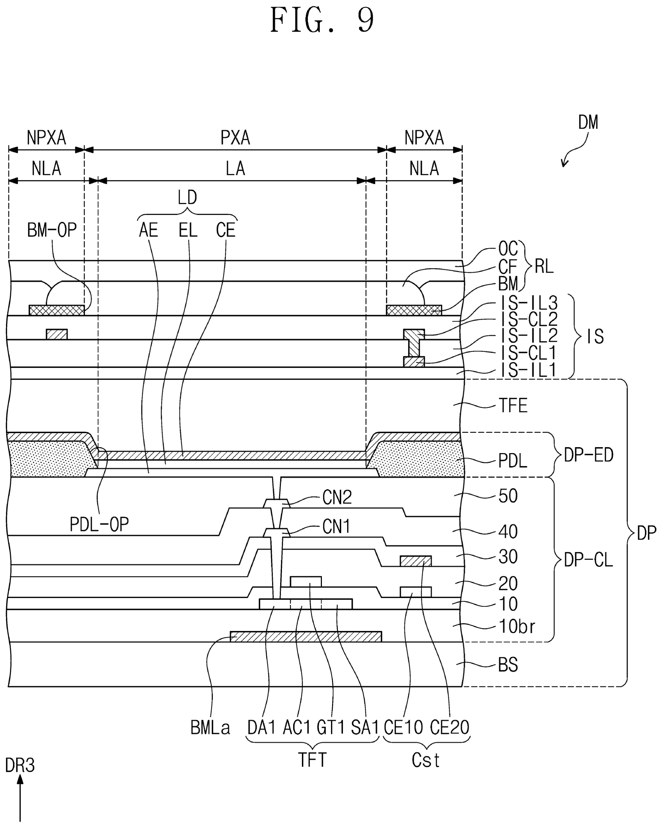

FIG. 9 is an enlarged cross-sectional view of the display module DM according to an embodiment of the present disclosure.

FIG. 9 shows a cross-section corresponding to one light emitting area LA and a non-light-emitting area NLA around the one light emitting area LA. FIG. 9 shows a cross-section of a light emitting element LD and a transistor TFT connected to the light emitting element LD, which are included in one pixel PX. The transistor TFT may be one selected from a plurality of transistors included in the driving circuit of the pixel PX. In the present embodiment, the transistor TFT will be described as a silicon transistor, however, according to an embodiment, the transistor TFT may be an oxide transistor.

In FIG. 9, the base layer BS is shown as a single layer. The base layer BS may include a synthetic resin such as polyimide. In an embodiment, the base layer BS may be formed by coating a synthetic resin layer on a work substrate (or a carrier substrate), and the work substrate may be removed after the display module DM is completed through subsequent processes.

The base layer BS may have a single-layer or multi-layer structure. For instance, the base layer BS may include a first synthetic resin layer, an intermediate layer having a single-layer or multi-layer structure, and a second synthetic resin layer, which are sequentially stacked. The intermediate layer may be referred to as a base barrier layer. The intermediate layer may include a silicon oxide (SiOx) layer and an amorphous silicon (a-Si) layer on the silicon oxide layer, however, it should not be particularly limited. As an example, the intermediate layer may include at least one selected from a silicon oxide layer, a silicon nitride layer, a silicon oxynitride layer, and an amorphous silicon layer.

Each of the first and second synthetic resin layers may include a polyimide-based resin. In embodiments, each of the first and second synthetic resin layers may include at least one selected from an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. In the present disclosure, the term "a"-based resin, as used herein, refers to the resin that includes a functional group of "a".

A buffer layer 10br may be on the base layer BS. The buffer layer 10br may prevent or reduce diffusion of metal atoms and/or impurities to the semiconductor pattern thereon from the base layer BS. The semiconductor pattern may include an active area AC1 of the transistor TFT.

A shielding pattern BMLa may be under the transistor TFT, and the shielding pattern BMLa may prevent or reduce incidence of the external light on the transistor TFT. The shielding pattern BMLa may be between the base layer BS and the buffer layer 10br. According to an embodiment, a barrier layer that is an inorganic layer may be further between the shielding pattern BMLa and the buffer layer 10br. The shielding pattern BMLa may be connected to an electrode and/or a line and may receive a constant voltage and/or signal from the electrode or the line.

The semiconductor pattern may be on the buffer layer 10br. The semiconductor pattern may include a silicon semiconductor. As an example, the silicon semiconductor may include amorphous silicon or polycrystalline silicon. For example, the semiconductor pattern may include low temperature polycrystalline silicon.

The semiconductor pattern may include a first region having a relatively high conductivity (e.g., electrical conductivity) and a second region having a relatively low conductivity (e.g., electrical conductivity). The first region may be doped with an N-type dopant or a P-type dopant. A P-type transistor may include a doped region doped with the P-type dopant, and an N-type transistor may include a doped region doped with the N-type dopant. The second region may be a non-doped region or a region doped at a concentration lower than that of the first region.

The first region may have a conductivity (e.g., electrical conductivity) greater than that of the second region and may substantially serve as an electrode and/or a signal line. The second region may substantially correspond to an active area (or a channel) of the transistor. In embodiments, a portion of the semiconductor pattern may be the active area of the transistor, another portion of the semiconductor pattern may be a source or a drain of the transistor, and the other portion of the semiconductor pattern may be a connection electrode and/or a connection signal line.

A source area (or source) SA1, the active area (or channel) AC1, and a drain area (or drain) DA1 of the transistor TFT may be formed from the semiconductor pattern. The source area SA1 and the drain area DA1 may extend in opposite directions to each other from the active area AC1 in a cross-section.

A first insulating layer 10 (e.g., a first electrically insulating layer 10) may be on the buffer layer 10br. The first insulating layer 10 may commonly overlap the pixels PX (refer to FIG. 4) and may cover the semiconductor pattern. The first insulating layer 10 may include an inorganic layer and/or an organic layer and may have a single-layer or multi-layer structure. The inorganic layer may include at least one selected from aluminum oxide, titanium oxide, silicon oxide, silicon nitride, silicon oxynitride, zirconium oxide, and hafnium oxide. In the present embodiment, the first insulating layer 10 may have a single-layer structure of a silicon oxide layer. Not only the first insulating layer 10, but also an insulating layer (e.g., an electrically insulating layer) of the circuit element layer DP-CL further described herein may be an inorganic layer and/or an organic layer and may have a single-layer or multi-layer structure. The inorganic layer may include at least one selected from the above-mentioned materials, however, it should not be limited thereto or thereby.

A gate GT1 of the transistor TFT may be on the first insulating layer 10. The gate GT1 may be a portion of a metal pattern. The gate GT1 may overlap the active area AC1. The gate GT1 may be used as a mask in a process of doping the semiconductor pattern. The gate GT1 may include titanium (Ti), silver (Ag), an alloy including silver (Ag), molybdenum (Mo), an alloy including molybdenum (Mo), aluminum (Al), an alloy including aluminum (Al), aluminum nitride (AIN), tungsten (W), tungsten nitride (WN), copper (Cu), indium tin oxide (ITO), indium zinc oxide (IZO), and/or the like, however, it should not be particularly limited.

A second insulating layer 20 (e.g., a second electrically insulating layer 20) may be on the first insulating layer 10 and may cover the gate GT1. A third insulating layer 30 (e.g., a third electrically insulating layer30) may be on the second insulating layer 20. A second electrode CE20 of a storage capacitor Cst may be between the second insulating layer 20 and the third insulating layer 30. In embodiments, a first electrode CE10 of the storage capacitor Cst may be between the first insulating layer 10 and the second insulating layer 20.

A first connection electrode CN1 may be on the third insulating layer 30. The first connection electrode CN1 may be connected to the drain area DA1 of the transistor TFT via a contact hole defined through the first, second, and third insulating layers 10, 20, and 30.

A fourth insulating layer 40 (e.g., a fourth electrically insulating layer 40) may be on the third insulating layer 30. A second connection electrode CN2 may be on the fourth insulating layer 40. The second connection electrode CN2 may be connected to the first connection electrode CN1 via a contact hole defined through the fourth insulating layer 40. A fifth insulating layer 50 (e.g., a fifth electrically insulating layer 50) may be on the fourth insulating layer 40 and may cover the second connection electrode CN2. The stack structure of the first insulating layer 10 to the fifth insulating layer 50 is merely an example, and an additional conductive layer (e.g., electrically conductive layer) and insulating layer (e.g., electrically insulating layer) may be provided in addition to the first insulating layer 10 to the fifth insulating layer 50.

Each of the fourth insulating layer 40 and the fifth insulating layer 50 may be an organic layer. As an example, the organic layer may include a general-purpose polymer such as benzocyclobutene (BCB), polyimide, hexamethyldisiloxane (HMDSO), polymethylmethacrylate (PMMA), and/or polystyrene (PS), a polymer derivative having a phenolic group, an acrylic-based polymer, an imide-based polymer, an aryl ether-based polymer, an amide-based polymer, a fluorine-based polymer, a p-xylene-based polymer, a vinyl alcohol-based polymer, and/or blends thereof.

The light emitting element LD may include a first electrode AE (or a pixel electrode), a light emitting layer EL, and a second electrode CE (or a common electrode). The first electrode AE may be on the fifth insulating layer 50. The first electrode AE may be a semi-transmissive electrode, a transmissive electrode, or a reflective electrode.

A pixel definition layer PDL may be on the fifth insulating layer 50. The pixel definition layer PDL may have a light absorbing property. For example, the pixel definition layer PDL may have a black color. The pixel definition layer PDL may include a black coloring agent. The black coloring agent may include a black dye and/or a black pigment. The black coloring agent may include a metal material, such as chromium, and/or an oxide thereof, and/or carbon black. The pixel definition layer PDL may correspond to a light shielding pattern having a light blocking property.

The pixel definition layer PDL may cover a portion of the first electrode AE, e.g., an anode. As an example, a pixel opening PDL-OP may be defined through the pixel definition layer PDL to expose the portion of the first electrode AE. The pixel opening PDL-OP of the pixel definition layer PDL may define the light emitting area LA.

The pixel definition layer PDL may increase a distance between an edge of the first electrode AE and the second electrode CE, e.g., a cathode. Accordingly, the occurrence of an arc in the edge of the first electrode AE may be prevented or reduced by the pixel definition layer PDL.

In embodiments, a hole control layer may be between the first electrode AE and the light emitting layer EL. The hole control layer may include at least a hole transport layer and may further include a hole injection layer. An electron control layer may be between the light emitting layer EL and the second electrode CE. The electron control layer may include at least an electron transport layer and may further include an electron injection layer.

The encapsulation layer TFE may be on the display element layer DP-ED. The encapsulation layer TFE may protect the display element layer DP-ED from moisture, oxygen, and a foreign substance such as dust particles. The encapsulation layer TFE may include at least one inorganic layer and one organic layer. The encapsulation layer TFE may have a stack structure of inorganic and organic layers. The encapsulation layer TFE will be described in more detail herein.

The input sensor IS may be on the display panel DP. The input sensor IS may include a first sensor insulating layer IS-IL1 (e.g., a first sensor electrically insulating layer IS-ILl1), a first sensor conductive layer IS-CL1 (e.g., a first sensor electrically conductive layer IS-CL1), a second sensor insulating layer IS-IL2 (e.g., a second sensor electrically insulating layer IS-IL2), a second sensor conductive layer IS-CL2 (e.g., a second sensor electrically conductive layer IS-CL2), and a third sensor insulating layer IS-IL3 (e.g., a third sensor electrically insulating layer IS-IL3). The first sensor insulating layer IS-IL1 may be directly on the encapsulation layer TFE.

In an embodiment, the first sensor insulating layer IS-IL1 and/or the third sensor insulating layer IS-IL3 may be omitted. If (e.g., when) the first sensor insulating layer 1S-IL1 is omitted, the first sensor conductive layer IS-CL1 may be directly on an uppermost insulating layer (e.g., an uppermost electrically insulating layer) of the encapsulation layer TFE. The third sensor insulating layer IS-IL3 may be replaced with an adhesive layer and/or an insulating layer (e.g., an electrically insulating layer) of the anti-reflector RL on the input sensor IS.

The first sensor conductive layer IS-CL1 may include first conductive patterns (e.g., first electrically conductive patterns), and the second sensor conductive layer IS-CL2 may include second conductive patterns (e.g., second electrically conductive patterns). The first conductive pattern IS-CL1 may be on the first sensor insulating layer IS-IL1. The second conductive pattern IS-CL2 may be on the second sensor insulating layer IS-IL2. Hereinafter, the first sensor conductive layer IS-CL1 and the first conductive patterns are assigned with the same reference numerals, and the second sensor conductive layer IS-CL2 and the second conductive patterns are assigned with the same reference numerals.

Each of the first conductive patterns IS-CL1 and the second conductive patterns IS-CL2 may have a single-layer structure or a multi-layer structure of layers stacked in the third direction DR3. The conductive pattern having the multi-layer structure may include at least two of transparent conductive layers and metal layers. The conductive pattern having the multi-layer structure may include metal layers containing different metals. The transparent conductive layer may include indium tin oxide (ITO), indium zinc oxide (IZO), zinc oxide (ZnO), indium tin zinc oxide (ITZO), PEDOT, metal nanowire, graphene, and/or the like. The metal layer may include molybdenum, silver, titanium, copper, aluminum, or alloys thereof.

Each of the first conductive patterns IS-CL1 and the second conductive patterns IS-CL2 may have a thickness greater than or equal to about 0.1 micrometers and smaller than or equal to about 1 micrometer. If (e.g., when) the thickness of each of the first conductive patterns IS-CL1 and the second conductive patterns IS-CL2 is smaller than about 0.1 micrometers, a resistance (e.g., electrical resistance) in wiring may increase, and thus, the input sensing performance of the input sensor IS may deteriorate. If (e.g., when) the thickness of each of the first conductive patterns IS-CL1 and the second conductive patterns IS-CL2 is greater than about 1 micrometer, the thickness of the input sensor IS may increase excessively, leading to an increase in a total thickness of the electronic device EA (refer to FIG. 3A) and a degradation of its folding properties.

In the present embodiment, each of the first sensor insulating layer IS-IL1 to the third sensor insulating layer IS-IL3 may include an inorganic layer or an organic layer. In the present embodiment, the first sensor insulating layer IS-IL1 to the third sensor insulating layer IS-IL3 may include the inorganic layer. The inorganic layer may include silicon oxide, silicon nitride, and/or silicon oxynitride.

According to an embodiment, at least one selected from the first sensor insulating layer 1S-IL1 to the third sensor insulating layer IS-IL3 may be the organic layer. For instance, the third sensor insulating layer IS-IL3 may include the organic layer. The organic layer may include at least one selected from an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin.

The anti-reflector RL may be on the input sensor IS. The anti-reflector RL may include a light blocking pattern BM, the color filter CF, and a planarization layer OC. In an embodiment, the light blocking pattern BM may be omitted.

A material for the light blocking pattern BM should not be particularly limited as along as the material may absorb light. The light blocking pattern BM may be a layer having a black color, and the light blocking pattern BM may include a black coloring agent. The black coloring agent may include a black dye and/or a black pigment. The black coloring agent may include a metal material, such as carbon black, chromium, or an oxide thereof.

The light blocking pattern BM may overlap the first conductive patterns IS-CL1 and the second conductive patterns IS-CL2 if (e.g., when) viewed in a plane. The light blocking pattern BM may prevent or reduce reflection of the external light by the first conductive patterns IS-CL1 and the second conductive patterns IS-CL2. An opening BM-OP may be defined through the light blocking pattern BM. The opening BM-OP of the light blocking pattern BM may overlap the first electrode AE and may have a size greater than that of the pixel opening PDL-OP of the pixel definition layer PDL. The opening BM-OP of the light blocking pattern BM may define a pixel area PXA. The pixel area PXA may be defined as an area from which the light generated by the light emitting element LD exits to the outside. As the size of the pixel area PXA increases, a luminance of the image may increase.

The color filter CF may overlap at least the pixel area PXA. The color filter CF may further overlap a non-pixel area NPXA. A portion of the color filter CF may be on the light blocking pattern BM. The color filter CF may transmit the light generated by the light emitting element LD and may block certain wavelength bands of the external light. Accordingly, the color filter CF may reduce the reflection of the external light by the first electrode AE or the second electrode CE.

The planarization layer OC may cover the light blocking pattern BM and the color filter CF. The planarization layer OC may include an organic material and may provide a flat upper surface.

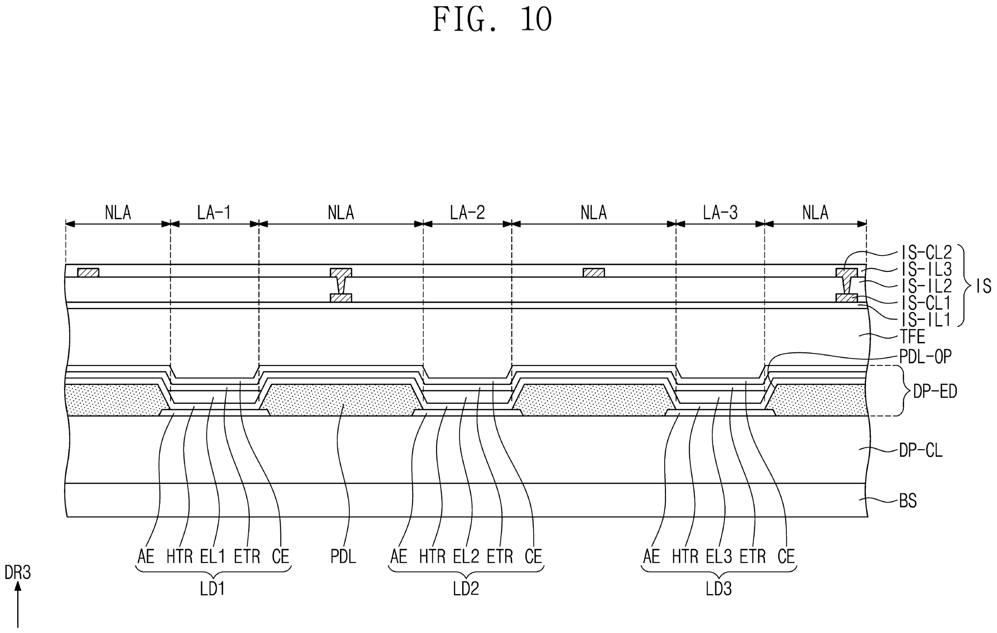

FIG. 10 is an enlarged cross-sectional view of the display module DM according to an embodiment of the present disclosure. FIG. 10 shows a cross-section corresponding to light emitting areas LA-1, LA-2, and LA-3 different from each other and adjacent to each other and the non-light-emitting area NLA surrounding the light emitting areas LA-1, LA-2, and LA-3. In FIG. 10, the anti-reflector RL described with reference to FIG. 9 is omitted.

Referring to FIG. 10, the base layer BS may have the single-layer or multi-layer structure. For instance, the base layer BS may include the first synthetic resin layer, the intermediate layer having the single-layer or multi-layer structure, and the second synthetic resin layer, which are sequentially stacked. The intermediate layer may be referred to as the base barrier layer. The intermediate layer may include the silicon oxide (SiOx) layer and the amorphous silicon (a-Si) layer on the silicon oxide layer, however, it should not be particularly limited. As an example, the intermediate layer may include at least one selected from the silicon oxide layer, the silicon nitride layer, the silicon oxynitride layer, and the amorphous silicon layer.

Each of the first and second synthetic resin layers may include the polyimide-based resin. In embodiments, each of the first and second synthetic resin layers may include at least one selected from the acrylic-based resin, the methacrylic-based resin, the polyisoprene-based resin, the vinyl-based resin, the epoxy-based resin, the urethane-based resin, the cellulose-based resin, the siloxane-based resin, the polyamide-based resin, and the perylene-based resin. In embodiments of the present disclosure, the term "a"-based resin, as used herein, refers to the resin that includes a functional group of "a".

The circuit element layer DP-CL may be on the base layer BS, and the circuit element layer DP-CL may include a plurality of transistors. Each of the transistors may include a control electrode, an input electrode, and an output electrode. As an example, the circuit element layer DP-CL may include a switching transistor and a driving transistor to drive light emitting elements LD1, LD2, and LD3 of the display element layer DP-ED.

The display element layer DP-ED may include the pixel definition layer PDL and the first, second, and third light emitting elements LD1, LD2, and LD3. A pixel opening PDL-OP may be defined through the pixel definition layer PDL. As an example, the pixel definition layer PDL may include an organic light shielding material and/or an inorganic light shielding material including a black pigment and a black dye.

The display panel DP may include the non-light-emitting area NLA and the light emitting areas LA-1, LA-2, and LA-3. The light emitting areas LA-1, LA-2, and LA-3 may be areas from which lights generated from the first, second, and third light emitting elements LD1, LD2, and LD3 exit, respectively. The light emitting areas LA-1, LA-2, and LA-3 may be spaced apart from each other If (e.g., when) viewed in the plane.

Each of the light emitting areas LA-1, LA-2, and LA-3 may be defined by the pixel definition layer PDL. The non-light-emitting areas NLA may be areas between the light emitting areas LA-1, LA-2, and LA-3 adjacent to each other and may correspond to the pixel definition layer PDL. In embodiments of the present disclosure, each of the light emitting areas LA-1, LA-2, and LA-3 may correspond to the pixel. The first, second, and third light emitting elements LD1, LD2, and LD3 may be distinguished from each other by the pixel definition layer PDL. Light emitting layers EL1, EL2, and EL3 of the first, second, and third light emitting elements LD1, LD2, and LD3 may be provided in the pixel opening PDL-OP defined through the pixel definition layer PDL and may be distinguished from each other.

The light emitting areas LA-1, LA-2, and LA-3 may be divided into a plurality of groups according to colors of the light generated by the first, second, and third light emitting elements LD1, LD2, and LD3. The display panel DP shown in FIG. 8 may include three light emitting areas LA-1, LA-2, and LA-3 that emit a red light, a green light, and a blue light, respectively. For example, the display module DM may include a red light emitting area LA-1, a green light emitting area LA-2, and a blue light emitting area LA-3, which are distinguished from each other.

The first, second, and third light emitting elements LD1, LD2, and LD3 may be spaced apart each other in one direction (e.g., the first direction DR1) perpendicular (e.g., substantially perpendicular) to the thickness direction DR3. The first, second, and third light emitting elements LD1, LD2, and LD3 may emit lights in different wavelength ranges. For example, the first light emitting element LD1 may emit red light, the second light emitting element LD2 may emit green light, and the third light emitting element LD3 may emit blue light. The red light emitting area LA-1, the green light emitting area LA-2, and the blue light emitting area LA-3 may correspond to the first light emitting element LD1, the second light emitting element LD2, and the third light emitting element LD3, respectively.

However, the present disclosure should not be limited thereto or thereby, and according to an embodiment, the first, second, and third light emitting elements LD1, LD2, and LD3 may emit lights in the same wavelength range, or at least one selected from the first, second, and third light emitting elements LD1, LD2, and LD3 may emit a light in a different wavelength range from the others. As an example, all the first, second, and third light emitting elements LD1, LD2, and LD3 may emit blue light.

Each of the light emitting elements LD1, LD2, and LD3 may include the first electrode AE, the second electrode CE above the first electrode AE, and the light emitting layers EL1, EL2, and EL3 between the first electrode AE and the second electrode CE. The first electrode AE may be exposed through the pixel opening PDL-OP of the pixel definition layer PDL.

In embodiments, each of the light emitting elements LD1, LD2, and LD3 may further include the hole control layer HTR and the electron control layer ETR. The hole control layer HTR may be between the first electrode AE and the light emitting layers EL1, EL2, and EL3. The electron control layer ETR may be between the second electrode CE and the light emitting layers EL1, EL2, and EL3.

FIG. 10 shows the structure in which the light emitting layers EL1, EL2, and EL3 of the first, second, and third light emitting elements LD1, LD2, and LD3 are provided in the pixel opening PDL-OP, which is defined through the pixel definition layer PDL, and the hole control layer HTR, the electron control layer ETR, and the second electrode CE are provided as a common layer across all the light emitting elements LD1, LD2, and LD3. However, the present disclosure should not be limited thereto or thereby. Unlike the display module shown in FIG. 10, according to an embodiment, the hole control layer HTR and the electron control layer ETR may be provided inside the pixel opening PDL-OP defined through the pixel definition layer PDL after being patterned. As an example, the hole control layer HTR, the light emitting layers EL1, EL2, and EL3, and the electron control layer ETR of the light emitting elements LD1, LD2, and LD3 may be provided after being patterned by an inkjet printing method.

The first electrode AE may be the anode, however, the present disclosure should not be limited thereto or thereby. The first electrode AE may also be the pixel electrode. The first electrode AE may be a transmissive electrode, a transflective electrode, or a reflective electrode. The first electrode AE may include at least one selected from Ag, Mg, Cu, Al, Pt, Pd, Au, Ni, Nd, Ir, Cr, Li, Ca, LiF, Mo, Ti, W, In, Sn, Zn, a compound of two or more thereof, a mixture of two or more thereof, and an oxide thereof.

If (e.g., when) the first electrode AE is the transmissive electrode, the first electrode AE may include a transparent metal oxide, for example, indium tin oxide (ITO), indium zinc oxide (IZO), zinc oxide (ZnO), and/or indium tin zinc oxide (ITZO). If (e.g., when) the first electrode AE is the transflective electrode or the reflective electrode, the first electrode AE may include Ag, Mg, Cu, Al, Pt, Pd, Au, Ni, Nd, Ir, Cr, Li, Ca, LiF/Ca (a stack structure of LiF and Ca), LiF/Al (a stack structure of LiF and Al), Mo, Ti, W, a compound thereof, and/or a mixture thereof, e.g., a mixture of Ag and Mg. In embodiments, the first electrode AE may have a multi-layer structure of the reflective layer or the transflective layer, which is formed of the materials described above, and a transparent conductive layer formed of indium tin oxide (ITO), indium zinc oxide (IZO), zinc oxide (ZnO), indium tin zinc oxide (ITZO), and/or the like. As an example, the first electrode AE may have a three-layer structure of ITO/Ag/ITO, however, it should not be limited thereto or thereby. As an example, the first electrode AE may include the above-described metal materials, a combination of two or more metal materials selected from the above-described metal materials, and/or oxides of the above-described metal materials, but it should not be limited thereto.

The hole control layer HTR may have a single-layer structure of a single material, a single-layer structure of different materials, or a multi-layer structure having a plurality of layers of different materials. The hole control layer HTR may include at least one selected from the hole injection layer, a hole transport layer, and an electron blocking layer. In embodiments, the hole control layer HTR may further include a light emitting auxiliary layer to compensate for a resonance distance according to a wavelength of the light emitted from the light emitting layers EL1, EL2, and EL3.

The hole control layer HTR may include a phthalocyanine compound such as copper phthalocyanine, DNTPD(N¹,N^{1'}-([1,1'-biphenyl]-4,4'-diyl)bis(N¹-phenyl-N⁴,N⁴-di-m-tolylbenzene-1,4-diamine)), m-MTDATA(4,4',4"-[tris(3-methylphenyl)phenylamino] triphenylamine), TDATA(4,4',4"-Tris(N,N-diphenylamino)triphenylamine), 2-TNATA(4,4',4"-tris[N(2-naphthyl)-N-phenylamino]-triphenylamine), PEDOT/PSS(Poly(3,4-ethylenedioxythiophene)/Poly(4-styrenesulfonate)), PANI/DBSA(Polyaniline/Dodecylbenzenesulfonic acid), PANI/CSA(Polyaniline/Camphor sulfonicacid), PANI/PSS(Polyaniline/Poly(4-styrenesulfonate)), NPB(N,N'-di(naphthalene-1-yl)-N,N'-diphenyl-benzidine), poly(ether ketone)-containing triphenylamine (TPAPEK), 4-Isopropyl-4'-methyldiphenyliodonium [Tetrakis(pentafluorophenyl)borate], HATCN(dipyrazino[2,3-f: 2',3'-h] quinoxaline-2,3,6,7,10,11-hexacarbonitrile), and/or the like.

In embodiments, the hole control layer HTR may include carbazole-based derivatives, e.g., n-phenyl carbazole, polyvinyl carbazole, and/or the like, fluorene-based derivatives, triphenylamine-based derivatives, e.g., TPD(N,N'-bis(3-methylphenyl)-N,N'-diphenyl-[1,1'-biphenyl]-4,4'-diamine), TCTA(4,4',4"-tris(N-carbazolyl)triphenylamine), TAPC(4,4'-Cyclohexylidene bis[N,N-bis(4-methylphenyl)benzenamine]), HMTPD(4,4'-Bis[N,N'-(3-tolyl)amino]-3,3'-dimethylbiphenyl), CzSi(9-(4-tert-Butylphenyl)-3,6-bis(triphenylsilyl)-9H-carbazole), CCP(9-phenyl-9H-3,9'-bicarbazole), mCP(1,3-Bis(N-carbazolyl)benzene), mDCP(1,3-bis(1,8-dimethyl-9H-carbazol-9-yl)benzene), and/or the like.

The light emitting layers EL1, EL2, and EL3 may have a single-layer structure of a single material, a single-layer structure of different materials, or a multi-layer structure having a plurality of layers of different materials. The light emitting layers EL1, EL2, and EL3 may include anthracene derivatives, pyrene derivatives, fluoranthene derivatives, chrysene derivatives, dihydrobenzanthracene derivatives, and/or triphenylene derivatives.

As an example, the light emitting layers EL1, EL2, and EL3 may include one host and one dopant. In embodiments, the light emitting layers EL1, EL2, and EL3 may include two or more hosts and two or more dopants.

The light emitting layer EL3 of the third light emitting element LD3 that emits the blue light may emit a thermally activated delayed fluorescence (TADF) and/or phosphorescence. The light emitting layer EL3 of the third light emitting element LD3 may include a thermally activated delayed fluorescent material and/or a phosphorescent material. The third light emitting element LD3 including the thermally activated delayed fluorescent material and/or the phosphorescent material may have excellent light emission efficiency.

The light emitting layers EL1, EL2, and EL3 may include any suitable dopant material generally used in the art. In embodiments, styryl derivatives, for example, 1, 4-bis[2-(3-N-ethylcarbazoryl)vinyl]benzene(BCzVB), 4-(di-p-tolylamino)-4'-[(di-p-tolylamino)styryl]stilbene(DPAVB), N-(4-((E)-2-(6-((E)-4-(diphenylamino)styryl)naphthalen-2-yl)vinyl)phenyl)-N-phenylbenzenamine(N-BDAVBI), 4,4'-bis[2-(4-(N,N-diphenylamino)phenyl)vinyl]biphenyl(DPAVBi), and/or the like, perylene and its derivatives, e.g., 2, 5, 8, 11-Tetra-t-butylperylene(TBP), pyrene and its derivatives, e.g., 1, 1-dipyrene, 1, 4-dipyrenylbenzene, 1, 4-Bis(N, N-Diphenylamino)pyrene, and/or the like may be used.

The light emitting layers EL1, EL2, and EL3 may include any suitable phosphorescent dopant material generally used in the art. As an example, the phosphorescent dopant material may include a metal complex including, for example, iridium (Ir), platinum (Pt), osmium (Os), gold (Au), titanium (Ti), zirconium (Zr), hafnium (Hf), europium (Eu), terbium (Tb) and/or thulium (Tm). In more detail, Flrpic (iridium(lll) bis(4,6-difluorophenylpyridinato-N,C2')picolinate), Fir6(Bis(2,4-difluorophenylpyridinato)-tetrakis(1-pyrazolyl)borate iridium(III)), and/or PtOEP (platinum octaethyl porphyrin) may be used as the phosphorescent dopant material, however, embodiments should not be limited thereto or thereby.

The electron control layer ETR may include at least one selected from a hole blocking layer, an electron transport layer, and an electron injection layer. The electron control layer ETR may have a single-layer structure of a single material, a single-layer structure of different materials, or a multi-layer structure having a plurality of layers of different materials.

The electron control layer ETR may include an anthracene-based compound, however, it should not be limited thereto or thereby. The electron control layer ETR may include, for example, Alq₃(Tris(8-hydroxyquinolinato)aluminum), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, TPBi(1,3,5-Tri(1-phenyl-1H-benzo[d]imidazol-2-yl)benzene), BCP(2,9-Dimethyl-4,7-diphenyl-1,10-phenanthroline), Bphen(4,7-Diphenyl-1,10-phenanthroline), TAZ(3-(4-Biphenylyl)-4-phenyl-5-tert-butylphenyl-1,2,4-triazole), NTAZ(4-(Naphthalen-1-yl)-3,5-diphenyl-4H-1,2,4-triazole), tBu-PBD(2-(4-Biphenylyl)-5-(4-tert-butylphenyl)-1,3,4-oxadiazole), BAlq(Bis(2-methyl-8-quinolinolato-N1,O8)-(1,1'-Biphenyl-4-olato)aluminum), Bebq₂ (berylliumbis(benzoquinolin-10-olate)), ADN(9,10-di(naphthalene-2-yl)anthracene), BmPyPhB (1,3-Bis[3,5-di(pyridin-3-yl)phenyl]benzene), or a mixture thereof.

In embodiments, the electron control layer ETR may include a metal halide, such as LiF, NaCl, CsF, RbCl, Rbl, Cul, KI, and/or the like, a lanthanum group metal, such as Yb, and/or a co-deposition material of the metal halide and the lanthanum group metal. For example, the electron control layer ETR may include Kl:Yb, Rbl:Yb, and/or LiF:Yb as the co-deposition material. The electron control layer ETR may include a metal oxide, such as Li₂O and/or BaO, or Liq (8-hydroxyl-Lithium quinolate), however, the embodiment should not be limited thereto or thereby. The electron control layer ETR may include a mixture of an electron transport material and an insulating organo-metallic salt (e.g., an electrically insulating organo-metallic salt). The organo-metallic salt may be a material having an energy band gap of about 4 eV or more. In more detail, the organo-metallic salt may include, for example, metal acetate, metal benzoate, metal acetoacetate, metal acetylacetonate, and/or metal stearate.

The second electrode CE may be a common electrode. The second electrode CE may be the cathode, however, the present disclosure should not be limited thereto or thereby. The second electrode CE may include at least one selected from Ag, Mg, Cu, Al, Pt, Pd, Au, Ni, Nd, Ir, Cr, Li, Ca, LiF, Mo, Ti, W, In, Sn, Zn, a compound of two or more thereof, a mixture of two or more thereof, and/or an oxide thereof.

In embodiments, the light emitting elements LD1, LD2, and LD3 may further include a capping layer above the second electrode CE. The capping layer may be an organic layer and/or an inorganic layer. As an example, if (e.g., when) the capping layer includes an inorganic material, the inorganic material may include an alkali metal compound, such as LiF, an alkaline earth metal compound, such as MgF₂, SiON, SiNx, SiOy, and/or the like. If (e.g., when) the capping layer includes an organic material, the organic material may include α-NPD, NPB, TPD, m-MTDATA, Alq₃, CuPc, TPD15(N4,N4,N4',N4'-tetra (biphenyl-4-yl) biphenyl-4,4'-diamine), TCTA(4,4',4"- Tris (carbazol-9-yl) triphenylamine), and/or the like, and/or may include an epoxy resin and/or an acrylate, such as methacrylate.

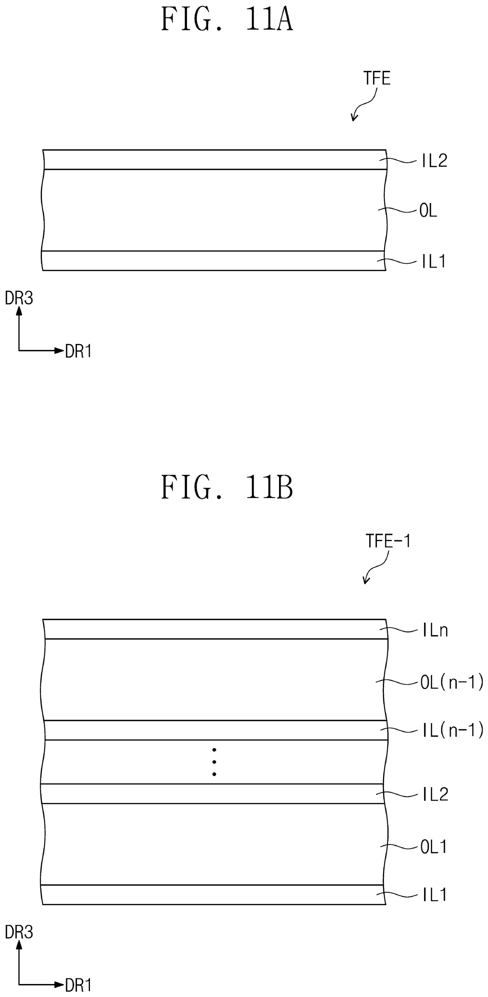

According to an embodiment, the encapsulation layer TFE may cover the display element layer DP-ED. The encapsulation layer TFE may be a thin film encapsulation layer. The encapsulation layer TFE may include at least one inorganic encapsulation layer and an organic encapsulation layer on the inorganic encapsulation layer. The encapsulation layer TFE will be described in more detail with reference to FIGS. 11A and 11B.

FIGS. 11A and 11B are cross-sectional views of encapsulation layers according to embodiments of the present disclosure. Descriptions of the encapsulation layers TFE and TFE-1 shown in FIGS. 11A and 11B may be applied to the encapsulation layer TFE included in the display panel DP of FIGS. 9 and 10. The encapsulation layers TFE and TFE-1 may include at least one inorganic encapsulation layer and at least one organic encapsulation layer.

Referring to FIG. 11A, the encapsulation layer TFE may include one organic encapsulation layer OL and two inorganic encapsulation layers IL1 and IL2, and the inorganic encapsulation layers IL1 and IL2 may be alternately stacked with the organic encapsulation layer OL. As an example, the encapsulation layer TFE may include the organic encapsulation layer OL between the two inorganic encapsulation layers IL1 and IL2.

The inorganic encapsulation layers IL1 and IL2 may be on the display element layer DP-ED and may protect the display element layer DP-ED from moisture and/or oxygen. Each of the first and second inorganic encapsulation layers IL1 and IL2 may include an inorganic material. Each of the first inorganic encapsulation layer IL1 and the second inorganic encapsulation layer IL2 may include at least one selected from silicon nitride, silicon oxynitride, and silicon oxide. In an embodiment, the first inorganic encapsulation layer IL1 and the second inorganic encapsulation layer IL2 may include titanium oxide and/or aluminum oxide, but the present disclosure should not be limited thereto or thereby. The first inorganic encapsulation layer IL1 and the second inorganic encapsulation layer IL2 may include the same material, however, the present disclosure should not be limited thereto or thereby. In an embodiment, the first inorganic encapsulation layer IL1 and the second inorganic encapsulation layer IL2 may include different materials. Each of the first and second inorganic encapsulation layers IL1 and IL2 may have a single-layer structure or a multi-layer structure of a plurality of layers. Each of the first and second inorganic encapsulation layers IL1 and IL2 may have a single-layer structure of a single inorganic material or a plurality of different inorganic materials or may have a multi-layer structure including a plurality of layers formed of different inorganic materials.

The first inorganic encapsulation layer IL1 may be on the display element layer DP-ED (refer to FIGS. 9 and 10). The first inorganic encapsulation layer IL1 may be directly on the display element layer DP-ED (refer to FIGS. 9 and 10). The first inorganic encapsulation layer IL1 may be directly on the light emitting elements LD, LD1, LD2, and LD3 described above with reference to FIGS. 9 and 10 and may cover the light emitting elements LD, LD1, LD2, and LD3. The first inorganic encapsulation layer IL1 may be directly on the second electrode CE (refer to FIGS. 9 and 10) of the light emitting elements LD, LD1, LD2, and LD3. If (e.g., when) the light emitting elements LD, LD1, LD2, and LD3 further include the capping layer, the first inorganic encapsulation layer IL1 may be directly on the capping layer.

The organic encapsulation layer OL may be on the first inorganic encapsulation layer IL1. The organic encapsulation layer OL may be directly on the first inorganic encapsulation layer IL1. The organic encapsulation layer OL may protect the display element layer DP-ED from foreign substances such as dust particles. The organic encapsulation layer OL may include an organic material further described herein.

The second inorganic encapsulation layer IL2 may be on the organic encapsulation layer OL. The second inorganic encapsulation layer IL2 may be directly on the organic encapsulation layer OL. The first inorganic encapsulation layer IL1, the organic encapsulation layer OL, and the second inorganic encapsulation layer IL2 may be sequentially stacked without any intermediate layer interposed therebetween.

An upper surface of the second inorganic encapsulation layer IL2 may define an uppermost surface of the encapsulation layer TFE. In the encapsulation layer TFE, no other components may be on the second inorganic encapsulation layer IL2. The input sensor IS (refer to FIG. 9) described above may be directly on an upper portion of the second inorganic encapsulation layer IL2. The first sensor insulating layer 1S-IL1 (refer to FIG. 9) of the input sensor IS (refer to FIG. 9) may be directly on the upper portion of the second inorganic encapsulation layer IL2. In the display panel DP (refer to FIG. 9), no other components may be on the second inorganic encapsulation layer IL2 included in the encapsulation layer TFE.

The organic encapsulation layer OL of the encapsulation layer TFE has a low dielectric constant. The organic encapsulation layer OL may include a material having a low dielectric constant. The organic encapsulation layer OL of the encapsulation layer TFE may have a low dielectric constant (Dk) of about 3.0 or less. For example, the dielectric constant (Dk) of the organic encapsulation layer OL may be greater than or equal to about 2.1 and smaller than or equal to about 2.83. Because the organic encapsulation layer OL has the low dielectric constant value of about 3.0 or less, a capacitance value between the light emitting element LD under the encapsulation layer TFE and the input sensor IS may be reduced, and thus, the sensitivity properties of the input sensor IS may be improved. In the present disclosure, the dielectric constant (Dk) may be measured using an LCR meter. The dielectric constant (Dk) may be evaluated, for example, at a temperature of 25°C and a frequency of 1 kHz.

The encapsulation layer TFE-1 according to the embodiment shown in FIG. 11B is the same as the encapsulation layer TFE described with reference to FIG. 11A except that the encapsulation layer TFE-1 includes a plurality of inorganic encapsulation layers IL1 to ILn and a plurality of organic encapsulation layers OL1 to OL(n-1).

Referring to FIG. 11B, the encapsulation layer TFE-1 may include n inorganic encapsulation layers IL1 to ILn including a first inorganic encapsulation layer IL1 on the light emitting element LD (refer to FIG. 9). In embodiments, the first inorganic encapsulation layer IL1 may be on the light emitting element LD (refer to FIG. 9) to be in direct contact with the light emitting element LD (refer to FIG. 9). The first inorganic encapsulation layer IL1 may be defined as a lower inorganic layer, and among the n inorganic encapsulation layers IL1 to ILn, inorganic layers other than the first inorganic encapsulation layer IL1 may be defined as upper inorganic encapsulation layers.

The encapsulation layer TFE-1 may include n-1 organic encapsulation layers OL1 to OL(n-1), and the n-1 organic encapsulation layers OL1 to OL(n-1) may be alternately stacked with the n inorganic encapsulation layers IL1 to ILn. The organic encapsulation layers OL1 to OL(n-1) may have a greater average thickness than the inorganic encapsulation layers IL1 to ILn.

Each of the inorganic encapsulation layers IL1 to ILn may have a single-layer structure of a single material or a multi-layer structure of two or more different materials. Each of the inorganic encapsulation layers IL1 to ILn may include at least one selected from silicon nitride, silicon oxynitride, and silicon oxide. For example, at least one selected from the inorganic encapsulation layers IL1 to ILn may include titanium oxide and/or aluminum oxide, however, the present disclosure should not be limited thereto or thereby.

At least one selected from the organic encapsulation layers OL1 to OL(n-1) may have the properties of the organic encapsulation layer OL (refer to FIG. 11A) according to the above-described embodiment. At least one selected from the organic encapsulation layers OL1 to OL(n-1) may include an organic material. For example, at least one selected from the organic encapsulation layers OL1 to OL(n-1) may include an organic material represented by any one selected from chemical formulas 1 to 3 and may exhibit a low dielectric constant.

The display module DM (refer to FIG. 9) may include the encapsulation layer TFE-1 according to the above-described embodiment. The display module DM may include at least one selected from the organic encapsulation layers OL1 to OL(n-1) having a low dielectric constant property and may exhibit improved sensitivity of the input sensor IS.

In the encapsulation layer TFE-1 shown in FIG. 11B, an upper surface of an n-th inorganic encapsulation layer ILn, which is at an uppermost position among the inorganic encapsulation layers IL1 to ILn, may define an uppermost surface of the encapsulation layer TFE-1. In the encapsulation layer TFE-1, no other components may be above the n-th inorganic encapsulation layer ILn. The input sensor IS (refer to FIG. 9) described above may be directly on an upper portion of the n-th inorganic encapsulation layer ILn. The first sensor insulating layer IS-IL1 (refer to FIG. 9) of the input sensor IS (refer to FIG. 9) may be directly on the upper portion of the n-th inorganic encapsulation layer ILn. In the display panel DP (refer to FIG. 9), no other components may be on the n-th inorganic encapsulation layer ILn included in the encapsulation layer TFE-1.

The organic encapsulation layers OL and OL1 to OL(n-1) described with reference to FIGS. 11A and 11B may include the organic material represented by any one selected from the following chemical formulas 1 to 3. The organic encapsulation layers OL and OL1 to OL(n-1) may include the organic material represented by any one selected from chemical formulas 1 to 3, and thus may exhibit the low dielectric constant. In embodiments, the organic encapsulation layers OL and OL1 to OL(n-1) including the organic material may exhibit the low dielectric constant properties while maintaining strength properties useful or required for use in the encapsulation layers TFE and TFE-1. Due to the low dielectric constant properties of the organic encapsulation layers OL and OL1 to OL(n-1), the encapsulation layers TFE and TFE-1 may reduce noise in the input sensor IS (refer to FIG. 9) on the encapsulation layer TFE and TFE-1 and may improve the touch sensitivity of the input sensor IS. For example, the encapsulation layer TFE and TFE-1 according to the present embodiment may include the organic material represented by any one selected from chemical formulas 1 to 3, and thus, the touch sensitivity of the input sensor IS may be improved. In more detail, the encapsulation layer TFE and TFE-1 according to the present embodiment may include the organic encapsulation layers OL and OL1 to OL(n-1) having the low dielectric constant properties and may reduce the capacitance between the second electrode CE under the encapsulation layer TFE and the sensor conductive layers IS-CL1 and IS-CL2 (refer to FIG. 9) on the encapsulation layer TFE, thereby improving the touch sensitivity of the input sensor IS.

In the present disclosure, "substituted" means that a hydrogen is substituted by a substituent selected from the group consisting of a deuterium atom, a halogen atom, a cyano group, a nitro group, an amine group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In embodiments, each of the substituents described above may be substituted or unsubstituted. For example, a biphenyl group may be interpreted as the aryl group or may be interpreted as a phenyl group substituted with a phenyl group.

In the present disclosure, "being bonded to a neighboring group to form a ring" may mean being bonded to a neighboring group to form a substituted or unsubstituted hydrocarbon ring, or a substituted or unsubstituted heterocycle. The hydrocarbon ring may include an aliphatic hydrocarbon ring and an aromatic hydrocarbon ring. The heterocycle may include an aliphatic heterocycle and an aromatic heterocycle. The hydrocarbon ring and heterocycle may be monocyclic or polycyclic. In embodiments, the ring formed by being bonded to each other may also be linked to another ring to form a spiro structure.

In the present disclosure, "a neighboring group" may mean a substituent substituted at an atom directly connected to an atom where a corresponding substituent is substituted, another substituent substituted at an atom where a corresponding substituent is substituted, or a substituent that is stereoscopically closest to a corresponding substituent. For example, two methyl groups in 1,2-dimethylbenzene may be interpreted as "neighboring groups", and two ethyl groups in 1,1-diethylcyclopentane may be interpreted as "neighboring groups". In embodiments, two methyl groups in 4,5-dimethylphenanthrene may be interpreted as "neighboring groups."

In the present disclosure, examples of a halogen atom are a fluorine atom, a chlorine atom, a bromine atom, or an iodine atom.

In the present disclosure, the alkyl group may be linear, branched, or cyclic. The number of carbon atoms in the alkyl group may be 1 to 50, 1 to 30, 1 to 20, 1 to 10, or 1 to 6. In embodiments where the alkyl group is cyclic, the number of carbon atoms in the alkyl group may be 3 to 50, 3 to 30, 3 to 20, or 3 to 10. The alkyl group may include, but is not limited to, a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, a n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldodecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, and a bicycloheptyl group.

In the present disclosure, the alkenyl group may refer to a hydrocarbon group containing one or more carbon-carbon double bonds at an intermediate or terminal position of an alkyl group having 2 or more carbon atoms. The alkenyl group may be linear or branched. The number of carbon atoms is not particularly limited, but is 2 to 30, 2 to 20, or 2 to 10. The alkenyl group may include a vinyl group, a 1-butenyl group, a 1-pentenyl group, a 1,3-butadienyl aryl group, a styrenyl group, and a styrylvinyl group, but it should not be limited thereto or thereby.

In the present disclosure, the hydrocarbon ring group may refer to any suitable functional group or substituent derived from an aliphatic hydrocarbon ring. The hydrocarbon ring group may be a saturated hydrocarbon ring group having 5 to 20 ring-forming carbon atoms.

In the present disclosure, the aryl group may refer to any suitable functional group or substituent derived from an aromatic hydrocarbon ring. The aryl group may be a monocyclic aryl group or a polycyclic aryl group. The number of ring-forming carbon atoms in the aryl group may be 6 to 30, 6 to 20, or 6 to 15. The aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like, however, embodiments should not be limited thereto or thereby.

In embodiments of the present disclosure, the heterocyclic group may refer to any suitable functional group or substituent derived from a ring that contains at least one selected from B, O, N, P, Si, and S as a heteroatom. The heterocyclic group may include an aliphatic heterocyclic group or an aromatic heterocyclic group. The aromatic heterocyclic group may be a heteroaryl group. Each of an aliphatic heterocycle or an aromatic heterocycle may be monocyclic or polycyclic.

In the present disclosure, the heterocyclic group may include at least one selected from B, O, N, P, Si, and S as a heteroatom. If (e.g., when) the heterocyclic group contains two or more heteroatoms, the two or more heteroatoms may be the same as or different from each other. The heterocyclic group may be a monocyclic heterocyclic group or a polycyclic heterocyclic group, and the heterocyclic group may include a heteroaryl group. The number of ring-forming carbon atoms in the heterocyclic group may be 2 to 30, 2 to 20, or 2 to 10.

In the present disclosure, the aliphatic heterocyclic group may include at least one selected from B, O, N, P, Si, or S as a heteroatom. The number of ring-forming carbon atoms in the aliphatic heterocyclic group may be 2 to 30, 2 to 20, or 2 to 10. The aliphatic heterocyclic group may include, but is not limited to, an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like.

In the present disclosure, the heteroaryl group may include at least one selected from B, O, N, P, Si, or S as a heteroatom. If (e.g., when) the heteroaryl group includes two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. The heteroaryl group may include, but is not limited to, a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzoimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like.

In the present disclosure, the oxy group may refer to a functional group that consists of an oxygen atom bonded to the alkyl group or the aryl group defined above. The oxy group may include an alkoxy group and an aryl oxy group. The alkoxy group may be linear, branched, or cyclic. The number of carbon atoms in the alkoxy group is not be particularly limited, but may be, for example, 1 to 20 or 1 to 10. The oxy group may include methoxy, ethoxy, n-propoxy, isopropoxy, butoxy, pentyloxy, hexyloxy, octyloxy, nonyloxy, decyloxy, benzyloxy, and/or the like, but embodiments should not be limited thereto.

In the present disclosure, the above description for the alkyl group may be applied to an alkylene group, except that the alkylene group is divalent. The above description for the aryl group may be applied to an arylene group, except that the arylene group is a divalent group. In the present disclosure, the above description for the heteroaryl group may be applied to a heteroarylene group, except that the heteroarylene group is a divalent group.

In the present disclosure, an alkyleneoxy group may refer to a divalent linking group including an alkylene moiety and an oxy moiety. For example, the alkyleneoxy group may refer to a divalent linking group in which a carbon atom of alkylene is bonded through an oxygen linking group represented by -O-. For example, the alkyleneoxy group may be a substituent represented by -R_{A}-O-, where R_{A} may be a substituted or unsubstituted alkylene group. The alkyleneoxy group may include, but is not limited to, a methyleneoxy group, an ethyleneoxy group, a propyleneoxy group, a butyleneoxy group, a sec-butyleneoxy group, a t-butyleneoxy group, a pentyleneoxy group, a hexyleneoxy group, a heptyleneoxy group, an octyleneoxy group, a 2-ethyl-hexyleneoxy group, and/or the like.

In the present disclosure, an aryleneoxy group may refer to a divalent linking group including an arylene moiety and an oxy moiety. For example, the aryleneoxy group may refer to a divalent linking group in which a carbon atom of an arylene is bonded through an oxygen linking group represented by -O-. For example, the aryleneoxy group may be a substituent represented by -Rs-O-, where R_{B} may be a substituted or unsubstituted arylene group. The aryleneoxy group may include, but is not limited to, a phenyleneoxy group, a biphenyleneoxy group, a terphenyleneoxy group, a quaterphenyleneoxy group, and/or the like.

In the present disclosure, a direct linkage may refer to a single bond (e.g., a single covalent bond).

In the present disclosure, "-*" may mean a linking position.

The organic material included in the organic encapsulation layers OL and OL1 to OL(n-1) in the encapsulation layers TFE and TFE-1 is represented by any one selected from the following chemical formulas 1 to 3.

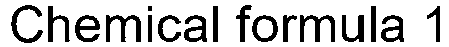

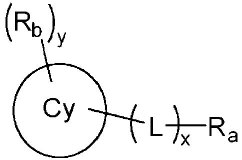

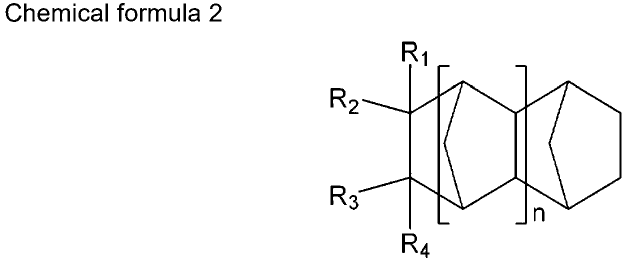

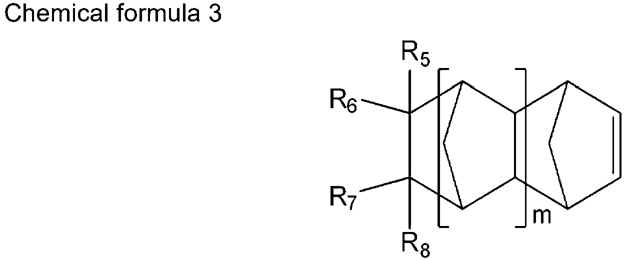

In chemical formula 1, Cy is a norbornane ring or a norbornene ring. In an embodiment, if (e.g., when) Cy is the norbornane ring, y is an integer from 0 to 11, and if (e.g., when) Cy is a norbornene ring, y is an integer from 0 to 9.

In an embodiment, if (e.g., when) Cy in chemical formula 1 is the norbornane ring, chemical formula 1 may be represented by the following chemical formula 1-a, and if (e.g., when) Cy is the norbornene ring, chemical formula 1 may be represented by the following chemical formula 1-b.

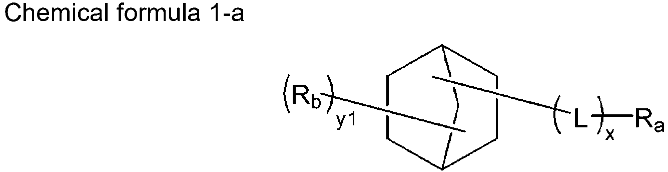

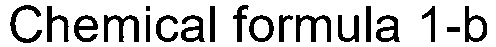

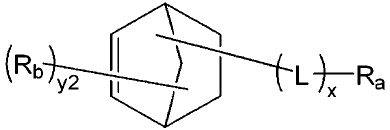

In chemical formula 1-a, y1 is an integer from 0 to 11, and in chemical formula 1-b, y2 is an integer from 0 to 9.

In chemical formulas 1-a and 1-b, Rₐ, R_{b}, L, and x are as defined in chemical formula 1.

In chemical formula 1, L is a direct linkage, a substituted or unsubstituted alkylene group having 1 to 20 carbon atoms, a substituted or unsubstituted alkyleneoxy group having 1 to 20 carbon atoms, or a substituted or unsubstituted aryleneoxy group having 6 to 30 ring-forming carbon atoms. For example, L may be the direct linkage or the substituted or unsubstituted alkylene group having 1 to 20 carbon atoms.

In chemical formula 1, Rₐ is a substituted or unsubstituted siloxane group, a substituted or unsubstituted cyclosiloxane group, a substituted or unsubstituted norbornane ring, a substituted or unsubstituted norbornene ring, or a substituted or unsubstituted alkyl group having 1 to 20 carbon atoms. In embodiments, Rₐ may be bonded with a neighboring group to form a ring.

In chemical formula 1, R_{b} is a hydrogen atom, a deuterium atom, a halogen atom, a substituted or unsubstituted siloxane group, a substituted or unsubstituted cyclosiloxane group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In embodiments, R_{b} may be bonded with a neighboring group to form a ring. For example, R_{b} may be a hydrogen atom.

In chemical formula 1, x is an integer from 1 to 10.

In chemical formulas 2 and 3, R₁ to R₈ are each independently a hydrogen atom, a deuterium atom, a halogen atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group 2 to 30 ring-forming carbon atoms. In embodiments, each of R₁ to R₈ may be bonded with a neighboring group to form a ring. For example, R₁ to R₈ may each independently be a hydrogen atom or a substituted or unsubstituted methyl group.

In chemical formulas 2 and 3, n and m are each independently an integer from 0 to 20.

In an embodiment, two selected from R₁ to R₄ in chemical formula 2 may be bonded to each other to form a ring. In chemical formula 2, R₂ and R₃ may be bonded to each other to form a saturated hydrocarbon ring, an unsaturated hydrocarbon ring, a saturated heterocyclic ring, or an unsaturated heterocyclic ring. For example, R₂ and R₃ in chemical formula 2 may be bonded to each other to form a saturated hydrocarbon ring or an unsaturated hydrocarbon ring, such as in structures 2-a to 2-g below. Structures 2-a to 2-g below illustrate embodiments where R₁ and R₄ in chemical formula 2 are hydrogen atoms and n is 0 as a representative example, however, the present disclosure should not be limited thereto or thereby.

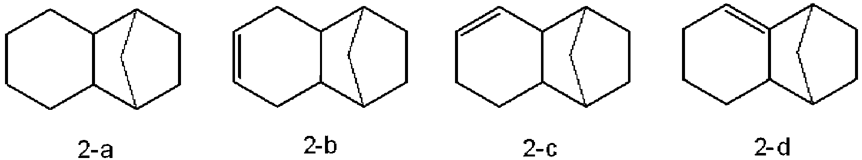

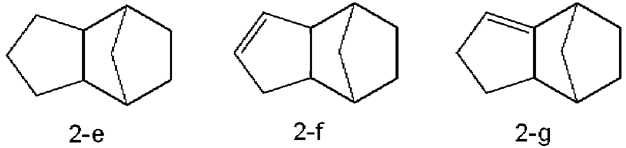

In an embodiment, two selected from R₅ to R₈ in chemical formula 3 may be bonded to each other to form a ring. In chemical formula 3, R₅ and R₈ may be bonded to each other to form a saturated hydrocarbon ring, an unsaturated hydrocarbon ring, a saturated heterocyclic ring, or an unsaturated heterocyclic ring. For example, R₆ and R₇ in chemical formula 3 may be bonded to each other to form a saturated hydrocarbon ring or an unsaturated hydrocarbon ring such as in structures 3-a to 3-g below. Structures 3-a to 3-g below illustrate embodiments where R₅ and R₈ in chemical formula 2 are hydrogen atoms and m is 0, however, the present disclosure should not be limited thereto or thereby.

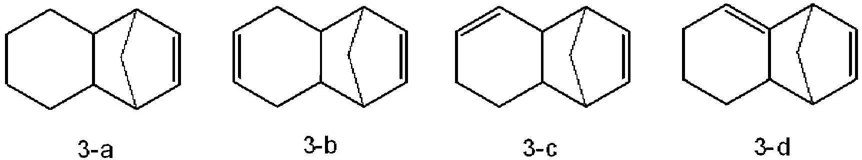

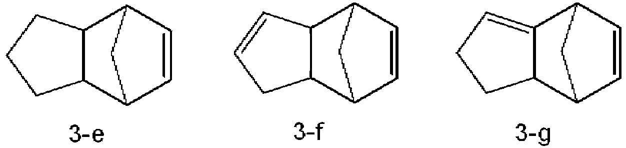

In an embodiment, the organic material represented by any one selected from chemical formulas 1 to 3 may not include a (meth)acrylate group in its molecular structure. In an embodiment, the organic material may not include a (meth)acrylate group as a substituent. For example, each of Rₐ, R_{b}, and L in chemical formula 1 may not include a (meth)acrylate group. For example, each of Rₐ, R_{b}, and L may not be a (meth)acrylate group or may not include a (meth)acrylate as a substituent. Further, each of R₁ to R₈ in chemical formulas 2 and 3 may not include a (meth)acrylate group.

In an embodiment, the substituted or unsubstituted siloxane group may be represented by the following chemical formula A.

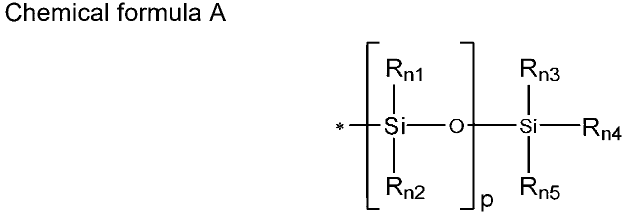

In chemical formula A, Rₙ₁ to Rₙ₅ may each independently be an alkoxy group having 1 to 20 carbon atoms, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Rₙ₁ to Rₙ₅ may each independently be a substituted or unsubstituted methyl group or a substituted or unsubstituted phenyl group.

In chemical formula A, p is an integer from 1 to 20. For example, p may be 1 or 2.

In an embodiment, the substituted or unsubstituted cyclosiloxane group may be represented by the following chemical formula B.

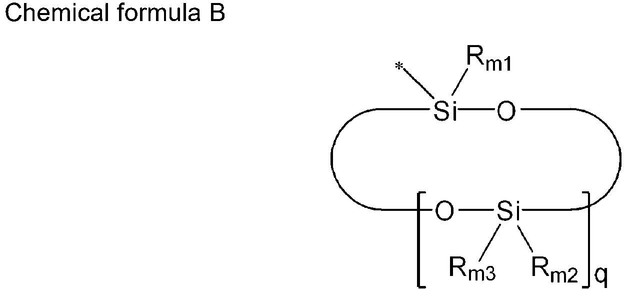

In chemical formula B, Rₘ₁ to Rₘ₃ may each independently be an alkoxy group having 1 to 20 carbon atoms, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Rₘ₁ to Rₘ₃ may each independently be a substituted or unsubstituted methyl group.

In chemical formula B, q is an integer from 1 to 5. For example, q may be 3.

In an embodiment, chemical formula B may be represented by the following chemical formula B-1 or chemical formula B-2.

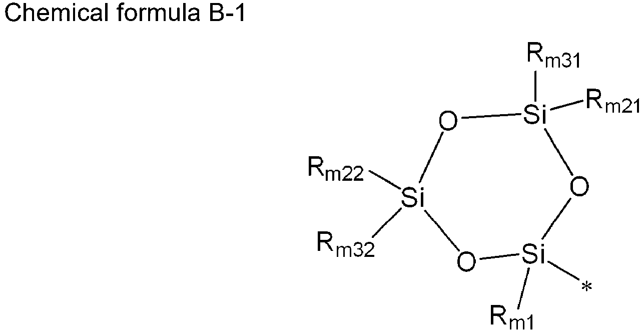

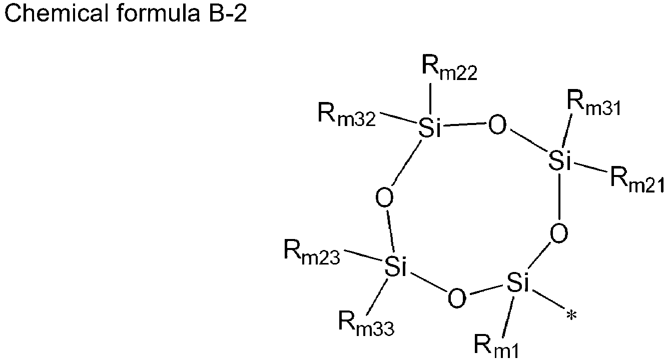

Chemical formulas B-1 and B-2 represent embodiments where q in chemical Formula B is specified. Chemical formula B-1 represents an embodiment where q in chemical formula B is 2, and chemical formula B-2 represents an embodiment where q in chemical formula B is 3.

In chemical formulas B-1 and B-2, Rₘ₂₁ to Rₘ₂₃ and Rₘ₃₁ to Rₘ₃₃ may each independently be an alkoxy group having 1 to 20 carbon atoms, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Rₘ₂₁ to Rₘ₂₃ and Rₘ₃₁ to Rₘ₃₃ may each independently be a substituted or unsubstituted methyl group.

In an embodiment, chemical formula 1 may be represented by any one selected from the following chemical formulas 1-1 to 1-5.

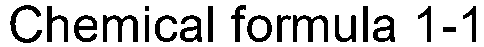

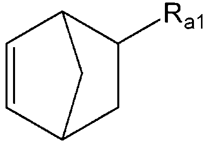

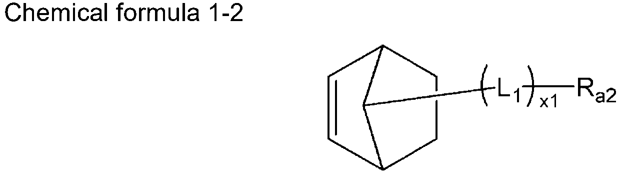

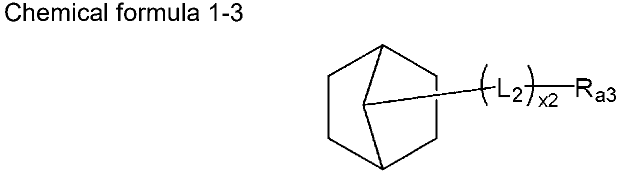

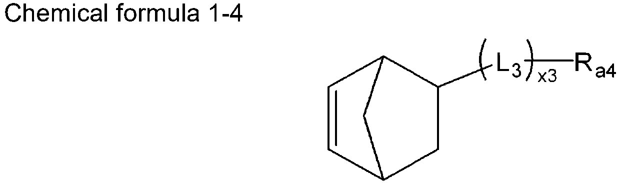

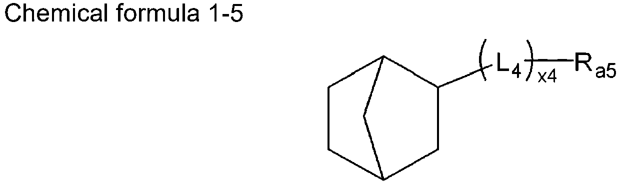

In chemical formula 1-1, Rₐ₁ may be a substituted or unsubstituted alkyl group having 1 to 10 carbon atoms. Rₐ₁ may be a substituted or unsubstituted methyl group, a substituted or unsubstituted ethyl group, a substituted or unsubstituted n-butyl group, a substituted or unsubstituted n-pentyl group, a substituted or unsubstituted n-hexyl group, a substituted or unsubstituted n-heptyl group, a substituted or unsubstituted n-octyl group, or a substituted or unsubstituted n-nonyl group.

In chemical formulas 1-2 to 1-4, Rₐ₂ to Rₐ₅ may each independently be a substituted or unsubstituted norbornane ring, a substituted or unsubstituted norbornene ring, a siloxane group represented by the above chemical formula A, or a cyclosiloxane group represented by the above chemical formula B.

In chemical formulas 1-2 to 1-4, L₁ to L₄ may each independently be a direct linkage, a substituted or unsubstituted alkylene group having 1 to 20 carbon atoms, or a substituted or unsubstituted alkyleneoxy group having 1 to 20 carbon atoms. In an embodiment, L₁ to L₄ may each independently be a direct linkage or a substituted or unsubstituted alkylene group having 1 to 20 carbon atoms.

In chemical formulas 1-2 to 1-4, x1 to x4 are each independently an integer from 1 to 10.

In an embodiment, the organic compound may include at least one selected from compounds in the following compound group 1. The organic compound according to an embodiment may be any one selected from the compounds included in the following compound group 1. The organic encapsulation layers OL and OL1 to OL(n-1) included in the encapsulation layers TFE and TFE-1 may include at least one organic material shown in compound group 1. The encapsulation layers TFE and TFE-1 may include at least one organic material among the compounds shown in compound group 1 in the organic encapsulation layers OL and OL1 to OL(n-1).

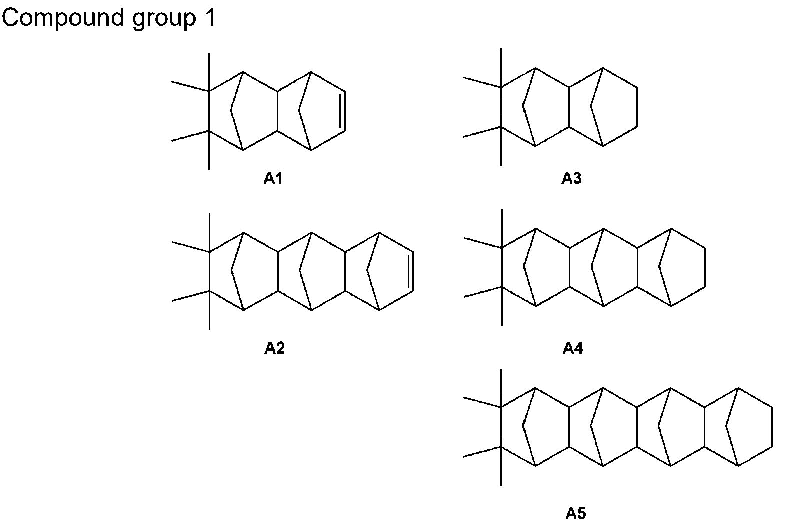

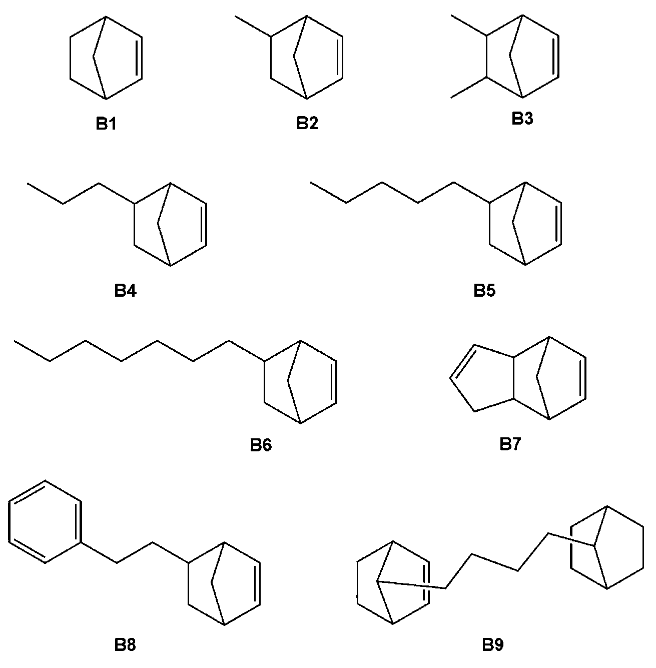

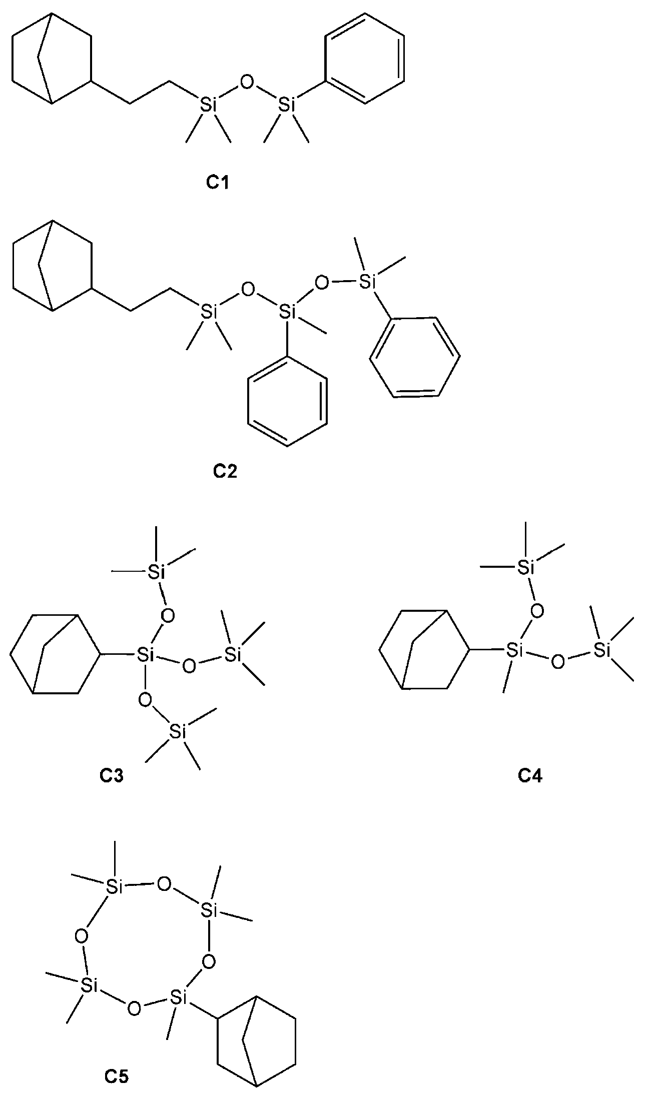

In embodiments, the encapsulation layers TFE and TFE-1 may include one or more compounds from compound group 1 described above.

In embodiments, the encapsulation layers TFE and TFE-1 may include the organic encapsulation layer OL and OL1 to OL(n-1) having the low dielectric properties and may improve the touch sensitivity of the input sensor IS thereon if (e.g., when) applied to the display panel. The organic encapsulation layer OL and OL1 to OL(n-1) of the encapsulation layers TFE and TFE-1 may include the organic material with the low dielectric constant (Dk), and thus, noise of the input sensor IS (refer to FIG. 9) on the encapsulation layers TFE and TFE-1 may be reduced, thereby improving the touch sensitivity of the input sensor IS.

In an embodiment, the organic encapsulation layer OL of the encapsulation layer TFE may include a polymer formed from an encapsulation composition that includes an organic material represented by any one selected from chemical Formulas 1 to 3 and a photoinitiator. In embodiments, the encapsulation composition may further include a crosslinker. For example, the organic encapsulation layer OL may include the polymer formed from the encapsulation composition that includes the organic material represented by any one selected from chemical formulas 1 to 3, the photoinitiator, and the crosslinker. The organic encapsulation layer OL may be formed from a polymerization reaction and a crosslinking reaction of the encapsulation composition.

In an embodiment, the organic encapsulation layer OL may have a dielectric constant of 3 or less. The organic encapsulation layer OL includes the organic material described above and may have a dielectric constant in a range from about 2.1 to about 2.83. For example, the organic encapsulation layer OL may have a dielectric constant value greater than or equal to about 2.1 and smaller than or equal to about 2.83 due to the characteristics of the organic material. The organic encapsulation layer OL may have a dielectric constant value greater than or equal to about 2.1 and smaller than or equal to about 2.83 due to the structural features of the organic material.

In an embodiment, the organic encapsulation layer OL included in the encapsulation layer TFE may have a glass transition temperature greater than or equal to about 60 °C and smaller than or equal to about 120 °C. The organic encapsulation layer OL may include the organic material and may exhibit the characteristic of having the glass transition temperature greater than or equal to about 60 °C and smaller than or equal to about 120 °C.

In an embodiment, the organic encapsulation layer OL included in the encapsulation layer TFE may have a refractive index greater than or equal to about 1.4 and smaller than or equal to about 1.6. The organic encapsulation layer OL may include the organic material and may exhibit the characteristic of having the refractive index greater than or equal to about 1.4 and smaller than or equal to about 1.6. In the present disclosure, the refractive index may be measured using an ellipsometer. The refractive index may be measured at 25°C with respect to light having a wavelength of 550nm.

In an embodiment, a Young's modulus of the organic encapsulation layer OL included in the encapsulation layer TFE at room temperature of about 25 °C may be greater than or equal to about 0.01 GPa and smaller than or equal to about 4 GPa. The organic encapsulation layer OL may include the organic material and may exhibit the characteristic of having the Young's modulus greater than or equal to about 0.01 GPa and smaller than or equal to about 4 GPa.

If (e.g., when) the Young's modulus value of the organic encapsulation layer OL is smaller than about 0.01 GPa, sufficient strength may not be secured. Accordingly, creases are formed if (e.g., when) the second inorganic encapsulation layer IL2 is formed on the organic encapsulation layer OL, and thus, reliability of thin films may be degraded. In embodiments, if (e.g., when) the Young's modulus value of the organic encapsulation layer OL exceeds about 4 GPa, its elasticity may decrease, and thus the organic encapsulation layer OL may become brittle easily. If (e.g., when) the Young's modulus value of the organic encapsulation layer OL satisfies the above range, a dimensional stability against external forces may be secured, and the strength suitable or sufficient to protect the functional layers under the encapsulation layer TFE may be secured.

In an embodiment, the organic encapsulation layer OL included in the encapsulation layer TFE may have a hardness in a range from about 0.01 GPa to about 0.2 GPa. The organic encapsulation layer OL may include the organic material and may exhibit the characteristic of having the hardness from about 0.01 GPa to about 0.2 GPa. As the organic encapsulation layer OL of the encapsulation layer TFE includes the organic material, the display module may have low dielectric constant properties while also having high strength properties. Because the organic encapsulation layer OL is formed to have high hardness, an increase in stress applied to layers during the deposition of the inorganic encapsulation layer may be reduced or prevented. The organic encapsulation layer OL has the hardness from about 0.01 GPa to about 0.2 GPa and the Young's modulus from about 0.01 GPa to about 4 GPa, and thus the effects described above may be achieved. In the present disclosure, the hardness may be measured using a nanoindenter. In the present disclosure, the Young's modulus may refer to a modulus representing a ratio of stress to strain. The Young's modulus may be a value measured at 25 °C.

In an embodiment, the organic encapsulation layer OL may have a thickness greater than or equal to about 3 micrometers and smaller than or equal to about 13 micrometers. If (e.g., when) the thickness of the organic encapsulation layer OL is less than about 3 micrometers, the organic encapsulation layer OL may not protect the display element layer DP-ED from foreign substances. Further, if (e.g., when) the thickness of the organic encapsulation layer OL exceeds about 13 micrometers, the organic encapsulation layer OL may reduce the emission of the light emitted from the display element layer DP-ED. The organic encapsulation layer OL with the thickness from about 3 micrometers to about 13 micrometers may exhibit excellent encapsulation reliability and may contribute to maintaining good display quality.

As the organic encapsulation layer OL includes the organic material represented by any one selected from chemical formulas 1 to 3, the organic encapsulation layer OL may exhibit the low dielectric constant properties, and concurrently (e.g., simultaneously), may maintain the strength properties suitable or required for use in the encapsulation layer TFE. In an embodiment, due to the low dielectric constant properties of the organic encapsulation layer OL, the encapsulation layer TFE may reduce noise in the input sensor IS (refer to FIG. 9) on the encapsulation layer TFE and may improve the touch sensitivity of the input sensor IS (refer to FIG. 9). For example, the encapsulation layer TFE including the organic encapsulation layer OL with the low dielectric constant properties may reduce the capacitance between the second electrode CE under the encapsulation layer TFE and the sensor conductive layers IS-CL1 and IS-CL2 (refer to FIG. 9) on the encapsulation layer TFE, and thus, the touch sensitivity of the input sensor IS may be improved.

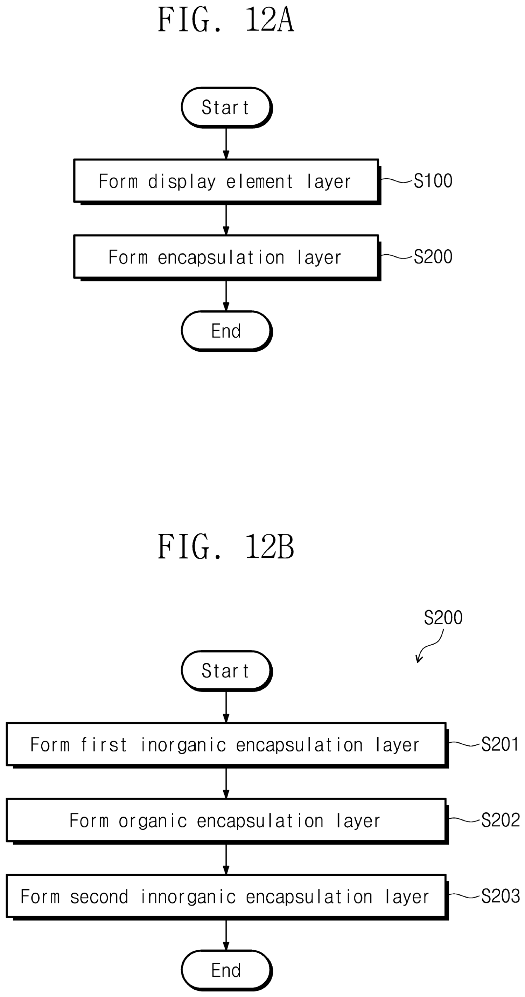

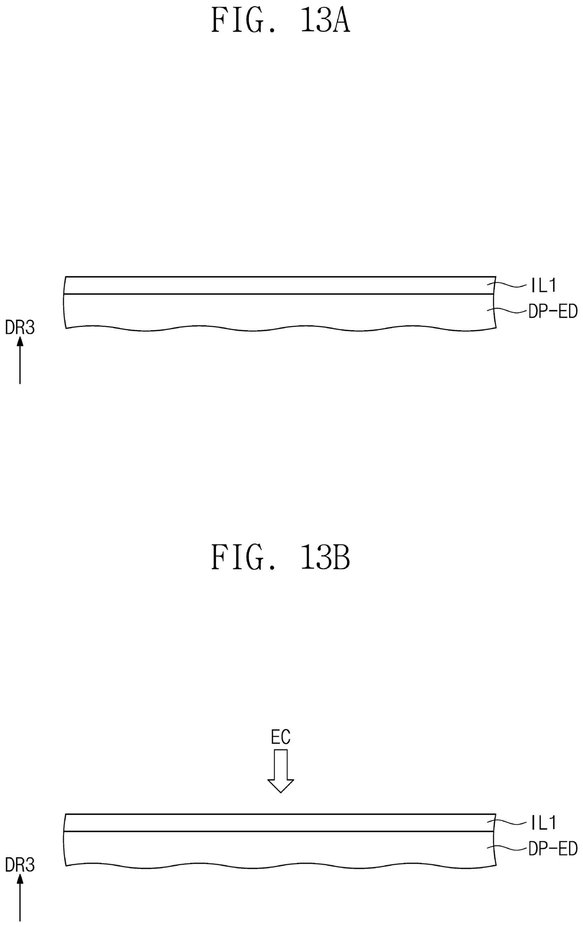

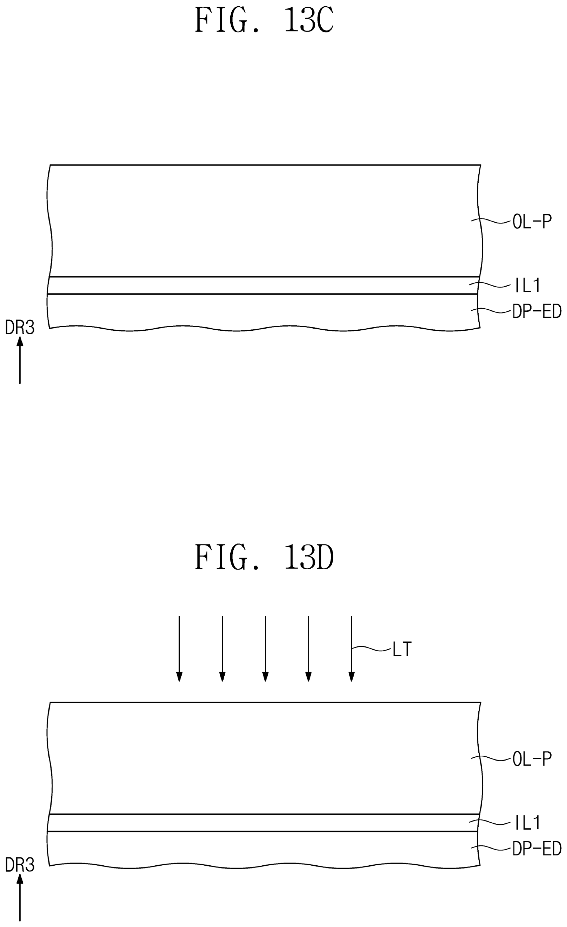

FIG. 12A is a flowchart illustrating a method of manufacturing the display module according to an embodiment of the present disclosure. FIG. 12B is a flowchart illustrating some processes of the manufacturing method of the display module according to an embodiment of the present disclosure. FIGS. 13A to 13F are cross-sectional views illustrating some processes of the manufacturing method of the display module according to an embodiment of the present disclosure. FIGS. 13A to 13F illustrate processes included in the forming of the encapsulation layer of the manufacturing method of the display module according to an embodiment of the present disclosure. FIGS. 13A to 13F are cross-sectional views showing the processes included in the forming of the encapsulation layer of the manufacturing method of the display module according to an embodiment of the present disclosure.

Referring to FIG. 12A, the manufacturing method of the display module may include forming the display element layer including the pixel definition layer and the light emitting element (S100) and forming the encapsulation layer on the display element layer to cover the light emitting element (S200).

Referring to FIG. 12B, the forming of the encapsulation layer (S200) may include forming the first inorganic encapsulation layer on the display element layer (S201), providing the encapsulation composition on the first inorganic encapsulation layer to form the organic encapsulation layer (S202), and forming the second inorganic encapsulation layer on the organic encapsulation layer (S203). For the configurations of the display element layer and the encapsulation layer, the descriptions provided with reference to FIGS. 7 to 11B may be identically applied.

FIGS. 13A to 13F sequentially illustrate the manufacturing processes of the encapsulation layer in the cross-section corresponding to FIG. 11A.

Referring to FIGS. 12B and 13A, the forming of the encapsulation layer (S200) of the manufacturing method of the display module may include the forming of the first inorganic encapsulation layer IL1 on the display element layer DP-ED (S201).

The first inorganic encapsulation layer IL1 may be formed by providing a first inorganic deposition material on an upper surface of the display element layer DP-ED. The first inorganic deposition material may include a silicon precursor. In an embodiment, the first inorganic deposition material may include at least one selected from silicon nitride, silicon oxide, and silicon oxynitride.

The first inorganic encapsulation layer IL1 may be directly formed on the display element layer DP-ED. The first inorganic encapsulation layer IL1 may be directly formed on the light emitting elements LD, LD1, LD2, and LD3 described with reference to FIGS. 9 and 10 and may cover the light emitting elements LD, LD1, LD2, and LD3. The first inorganic encapsulation layer IL1 may be directly formed on the second electrode CE of the light emitting elements LD, LD1, LD2, and LD3. In embodiments where the light emitting elements LD, LD1, LD2, and LD3 further include the capping layer, the first inorganic encapsulation layer IL1 may be directly formed on the capping layer.

The first inorganic encapsulation layer IL1 may be formed through various suitable methods, such as plasma-enhanced atomic layer deposition (PEALD), plasma-enhanced chemical vapor deposition (PECVD), sputtering, thermal evaporation, and/or e-beam evaporation process.

Referring to FIG. 12B and FIGS. 13B to 13E, the forming of the encapsulation layer (S200) of the manufacturing method of the display module may include forming the organic encapsulation layer OL on the first inorganic encapsulation layer IL1 (S202). The organic encapsulation layer OL may be formed by providing the encapsulation composition EC on the first inorganic encapsulation layer IL1. The organic encapsulation layer OL may be directly formed on the first inorganic encapsulation layer IL1.

Embodiments of the manufacturing method of the display module may include coating the encapsulation composition EC on the first inorganic encapsulation layer IL1 to form a preliminary organic encapsulation layer OL-P and irradiating a light to the preliminary organic encapsulation layer OL-P to form the organic encapsulation layer OL. The encapsulation composition EC may be provided through various suitable methods such as an inkjet printing process, a screen printing process, a spin coating process, a slit coating process, and/or the like.

The encapsulation composition EC may include the above-described organic material. The encapsulation composition EC may include the organic material represented by any one selected from chemical formulas 1 to 3. The organic material represented by any one selected from chemical formulas 1 to 3 may be the material having the low dielectric constant. The organic material may have the dielectric constant (Dk) greater than or equal to about 2.1 and smaller than or equal to about 2.83.

The organic material may be a component that constitutes the majority of the encapsulation composition EC. The organic material may be included in an amount in a range from 60 wt% to 80 wt% based on 100 wt% of a total content of the encapsulation composition EC. If (e.g., when) the organic material is included within the above range, the dielectric constant of the subsequently formed organic encapsulation layer OL may be effectively lowered. At the same time, the strength properties of the organic encapsulation layer OL may be suitably or sufficiently maintained, and thus, the durability characteristics of the entire encapsulation layer TFE may be improved. In an embodiment where the content of the organic material is less than about 60 wt%, suitable or sufficient voids by the organic material may not be secured, and the effect of reducing the dielectric constant of the organic encapsulation layer OL may not be obtained. Further, in an embodiment where the content of the organic material exceeds about 80 wt%, the strength of the organic encapsulation layer OL may be degraded.

The encapsulation composition EC may further include the photoinitiator. The photoinitiator may be excited by ultraviolet light and/or the like in an ink composition according to an embodiment of the present disclosure and may initiate photopolymerization. The photoinitiator may have a maximum absorbance in a wavelength range greater than or equal to about 305 nm and smaller than or equal to about 405 nm. As for the photoinitiator, any suitable initiator generally used in the art may be used without limitation.

The photoinitiator may be included in an amount in a range from 1 wt% to 10 wt% based on 100 wt% of the total content of the encapsulation composition EC. If (e.g., when) the photoinitiator is included within the above range in the ink composition of the present disclosure, sufficient curing may occur during light exposure, and thus, the reliability of the organic encapsulation layer OL may be improved. Further, excellent effects may be provided in terms of the durability of the formed layers, and defects caused by unreacted monomers may be prevented or reduced.

The encapsulation composition EC may further include the crosslinker. The crosslinker may increase the degree of cross-linking of the encapsulation composition EC to enhance the mechanical strength of the organic encapsulation layer OL. The type (or kind) of crosslinker should not be particularly limited, and any suitable materials may be used without limitation. For example, an organic crosslinker and/or polyfunctional metal chelate may be used as the crosslinker. The organic crosslinker may include an isocyanate-based crosslinker, a carbodiimide crosslinker, an oxazoline-based crosslinker, a peroxide-based crosslinker, an epoxy-based crosslinker, and/or an imine-based crosslinker. The polyfunctional metal chelate may include those in which a polyvalent metal is covalently or coordinately bonded to an organic compound. Polyvalent metal atoms may include Al, Cr, Zr, Co, Cu, Fe, Ni, V, Zn, In, Ca, Mg, Mn, Y, Ce, Sr, Ba, Mo, La, Sn, and/or Ti. The atom within the organic compound that forms covalent or coordinate bonds includes oxygen atom, and the organic compound may include an alkyl ester, an alcohol compound, a carboxylic acid compound, an ether compound, a ketone compound, and/or the like.

In an embodiment, the encapsulation composition may include the organic material, the photoinitiator, and the crosslinker. The organic encapsulation layer OL formed from the encapsulation composition according to the embodiment may be formed through cross-linking between polymers formed from the organic material or through cross-linking between adjacent functional groups within a single polymer.

The crosslinker may be included in an amount in a range from 20 wt% to 40 wt% based on 100 wt% of the total content of the encapsulation composition EC. As the content of the crosslinker satisfies the above range, a viscosity and cross-linking density of the encapsulation composition EC may be suitably or appropriately controlled, and thus, the durability of the layers after curing may be improved.

The encapsulation composition EC may further include, without limitation, any suitable functional additives generally used in the art, to an extent that they do not hinder or reduce the effects of embodiments of the present disclosure. Examples of usable functional additives may include, but are not limited to, polymerization catalysts, antioxidants, lubricants, surfactants, adhesion promoters, slip agents, wetting agents, light stabilizers, anti-stain agents, softeners, thickeners, polymers, and the like. These may be used individually or in a combination of two or more.

In an embodiment, the encapsulation composition EC may not include a solvent. In an embodiment, the encapsulation composition EC may be a solvent-free type (or kind) composition containing the organic material, the photoinitiator, and the crosslinker.

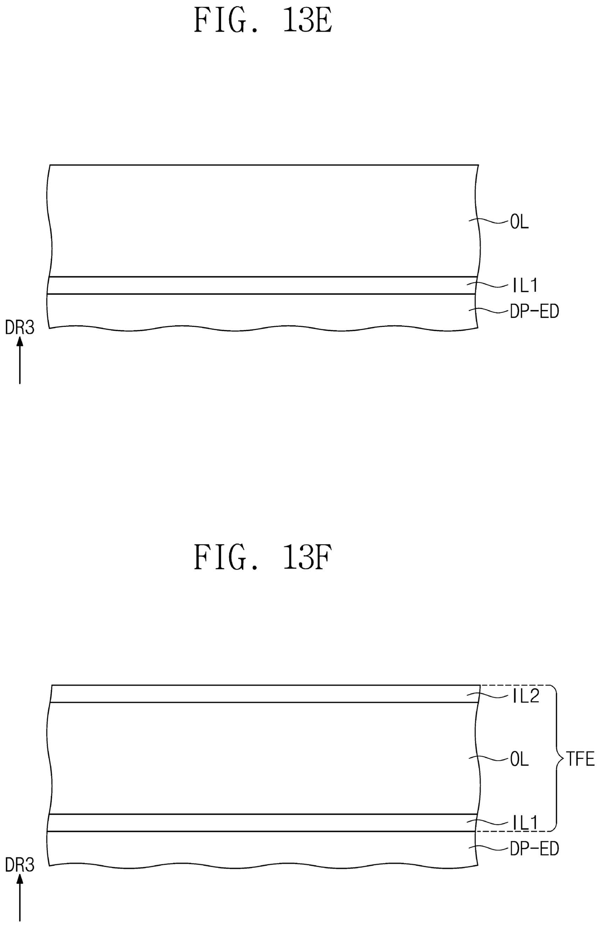

Referring to FIG. 13D, a light LT for curing may be provided to the preliminary organic encapsulation layer OL-P, which is formed by applying the encapsulation composition EC onto the first inorganic encapsulation layer IL1 and has a selected thickness. The light LT may be ultraviolet light, but it should not be limited thereto or thereby. The light LT may be provided to the entire region of the preliminary organic encapsulation layer OL-P. The preliminary organic encapsulation layer OL-P may be cured to form the organic encapsulation layer OL as shown in FIG. 13E.

The organic encapsulation layer OL formed by curing the preliminary organic encapsulation layer OL-P may include a polymer formed by the polymerization reaction of the organic material represented by chemical formulas 1 to 3. The polymerization reaction of the organic material may be performed by the light LT. For example, the process of providing the light LT to the preliminary organic encapsulation layer OL-P may include the polymerization reaction of the organic material contained in the preliminary organic encapsulation layer OL-P. The organic material may be polymerized by various suitable types (or kinds) of polymerization reactions. For example, the organic material may be polymerized by methods such as radical or cationic polymerization through a norbornene ring or norbornane ring, ring-opening metathesis polymerization (ROMP), or vinyl-addition polymerization, or may be polymerized by hydrolysis polycondensation of siloxane groups, a ring-opening polymerization of cyclosiloxane, and/or the like, but it should not be limited thereto or thereby. As described above, because the organic encapsulation layer OL includes the polymer formed by the polymerization reaction of the organic material through the norbornane ring, norbornene ring, siloxane group, or cyclosiloxane group, the organic encapsulation layer OL may have high hardness properties while maintaining the low dielectric constant properties.

Referring to FIGS. 12B and 13F, the forming of the encapsulation layer (S200) in the manufacturing method of the display module according to the present disclosure may include the forming of the second inorganic encapsulation layer IL2 on the organic encapsulation layer OL (S203).

The second inorganic encapsulation layer IL2 may be formed by providing a second inorganic deposition material on an upper surface of the organic encapsulation layer OL. In an embodiment, the second inorganic deposition material may include a silicon precursor. In an embodiment, the second inorganic deposition material may include at least one selected from silicon nitride, silicon oxide, and silicon oxynitride. The second inorganic encapsulation layer IL2 may be formed directly on the organic encapsulation layer OL.

The second inorganic encapsulation layer IL2 may be formed through various suitable methods, such as plasma-enhanced atomic layer deposition (PEALD), plasma-enhanced chemical vapor deposition (PECVD), sputtering, thermal evaporation, and/or e-beam evaporation process.

According to the manufacturing method of the display module, after the second inorganic encapsulation layer IL2 is formed, the input sensor IS (refer to FIG. 9) may be formed on the second inorganic encapsulation layer IL2. The first sensor insulating layer IS-IL1 (refer to FIG. 9) may be directly formed on the second inorganic encapsulation layer IL2.

Further, according to the manufacturing method of the display module, after the forming of the second inorganic encapsulation layer IL2, the forming of the organic encapsulation layer and the forming of the inorganic encapsulation layer may be sequentially repeated n or more times. For example, after the forming of the first inorganic encapsulation layer IL1, the organic encapsulation layer OL, and the second inorganic encapsulation layer IL2as described with reference to FIGS. 13A to 13F, the forming of the organic encapsulation layer and the forming of the inorganic encapsulation layer may be sequentially performed n or more times on the second inorganic encapsulation layer IL2. In the present embodiment, n is an integer of 1 or more. Then, the input sensor IS (refer to FIG. 9) may be formed on an uppermost inorganic encapsulation layer among the inorganic encapsulation layers included in the encapsulation layer TFE. The first sensor insulating layer IS-IL1 may be formed directly on the uppermost inorganic encapsulation layer among the inorganic encapsulation layers included in the encapsulation layer TFE.

Accordingly, the organic encapsulation layer OL included in the encapsulation layer TFE may be formed from the encapsulation composition EC that contains the organic material represented by any one selected from chemical formulas 1 to 3. In embodiments, the organic encapsulation layer OL, which includes the polymer formed from the encapsulation composition EC containing the organic material, may have the low dielectric constant properties due to the formation of voids by the structural properties of the polymer. Further, due to the low dielectric constant properties of the organic encapsulation layer OL, noise in the input sensor IS (refer to FIG. 9) on the encapsulation layer TFE may be reduced, and the touch sensitivity of the input sensor IS (refer to FIG. 9) may be improved. For example, the encapsulation layer TFE, by including the organic encapsulation layer OL having the above low dielectric constant properties, may reduce the capacitance between the second electrode CE under the encapsulation layer TFE and the sensor conductive layers IS-CL1 and IS-CL2 (refer to FIG. 9) above the encapsulation layer TFE, thereby improving the touch sensitivity of the input sensor IS.

## Claims

1. A display module comprising:
a display element layer comprising a pixel definition layer through which a pixel opening is defined and a light emitting element; and
an encapsulation layer on the display element layer, the encapsulation layer comprising:
a first inorganic encapsulation layer on the display element layer;
an organic encapsulation layer on the first inorganic encapsulation layer; and
a second inorganic encapsulation layer on the organic encapsulation layer, wherein the organic encapsulation layer comprises an organic material represented by any one selected from the following chemical formulas 1 to 3, 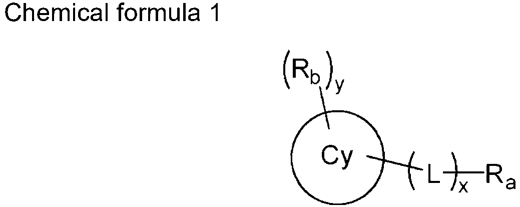 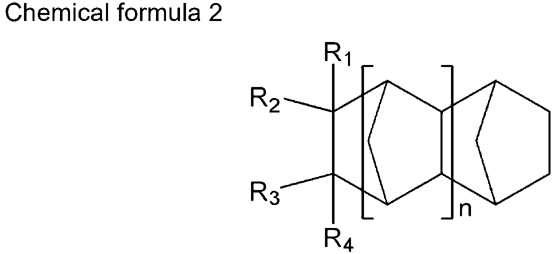 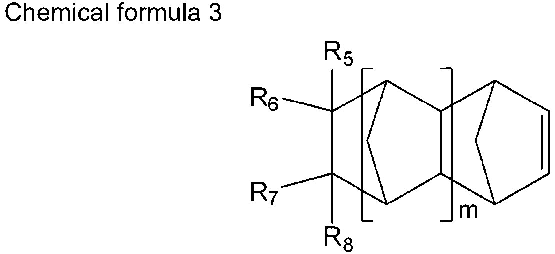
wherein, in chemical formulas 1 to 3,
Cy is a norbornane ring or a norbornene ring,
L is a direct linkage, a substituted or unsubstituted alkylene group having 1 to 20 carbon atoms, a substituted or unsubstituted alkyleneoxy group having 1 to 20 carbon atoms, or a substituted or unsubstituted aryleneoxy group having 6 to 30 ring-forming carbon atoms,
Rₐ is a substituted or unsubstituted siloxane group, a substituted or unsubstituted cyclosiloxane group, a substituted or unsubstituted norbornane ring, a substituted or unsubstituted norbornene ring, or a substituted or unsubstituted alkyl group having 1 to 20 carbon atoms, or is bonded with a neighboring group to form a ring,
R_{b} is a hydrogen atom, a deuterium atom, a halogen atom, a substituted or unsubstituted siloxane group, a substituted or unsubstituted cyclosiloxane group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or is bonded with a neighboring group to form a ring,
x is an integer from 1 to 10,
y is an integer from 0 to 11 if Cy is the norbornane ring, y is an integer from 0 to 9 if Cy is the norbornene ring,
R₁ to R₈ are each independently a hydrogen atom, a deuterium atom, a halogen atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or are bonded with a neighboring group to form the ring, and n and m are each independently an integer from 0 to 20,
wherein "substituted" means that hydrogen is substituted by a substituent selected from the group consisting of a deuterium atom, a halogen atom, a cyano group, a nitro group, an amine group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

2. The display module of claim 1, wherein the organic encapsulation layer is directly on the first inorganic encapsulation layer, and the second inorganic encapsulation layer is directly on the organic encapsulation layer.

3. The display module of claim 1 or 2, wherein the organic encapsulation layer has a thickness greater than or equal to 3 micrometers and smaller than or equal to 13 micrometers,
the organic encapsulation layer has a dielectric constant greater than or equal to about 2.1 and smaller than or equal to about 2.83,
the organic encapsulation layer has a refractive index greater than or equal to about 1.4 and smaller than or equal to about 1.6, and
the organic encapsulation layer has a hardness from 0.01 GPa to 0.2 GPa and a modulus from 0.01 GPa to 4 GPa.

4. The display module of any one of the preceding claims, wherein each of the first inorganic encapsulation layer and the second inorganic encapsulation layer comprises at least one selected from silicon nitride, silicon oxide, and silicon oxynitride.

5. The display module of any one of the preceding claims, wherein the chemical formula 1 is represented by any one selected from the following chemical formulas 1-1 to 1-5, 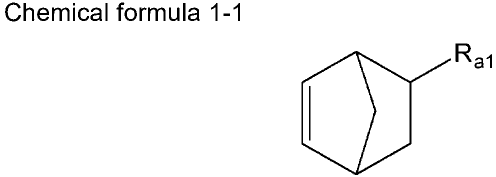 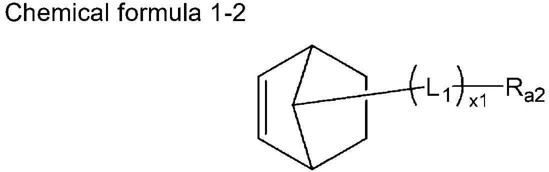 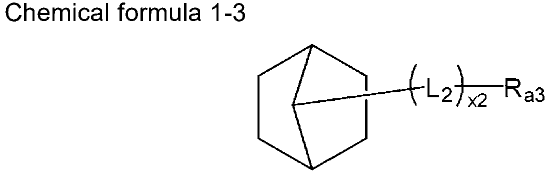 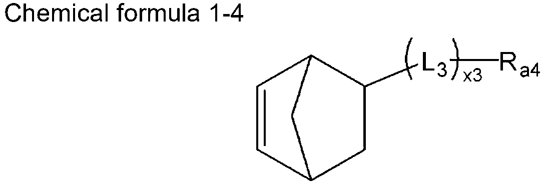 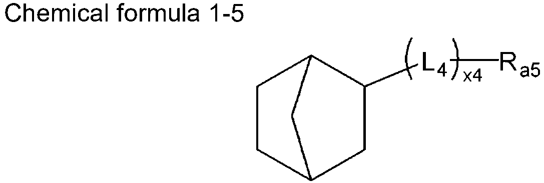
wherein, in chemical formulas 1-1 to 1-5, Rₐ₁ is a substituted or unsubstituted alkyl group having 1 to 10 carbon atoms, Rₐ₂ to Rₐ₅ are each independently a substituted or unsubstituted norbornane ring, a substituted or unsubstituted norbornene ring, a siloxane group represented by the following chemical formula A, or a cyclosiloxane group represented by the following chemical formula B, L₁ to L₄ are each independently a direct linkage, a substituted or unsubstituted alkylene group having 1 to 20 carbon atoms, or a substituted or unsubstituted alkyleneoxy group having 1 to 20 carbon atoms, x₁ to x₄ are each independently an integer from 1 to 10, and 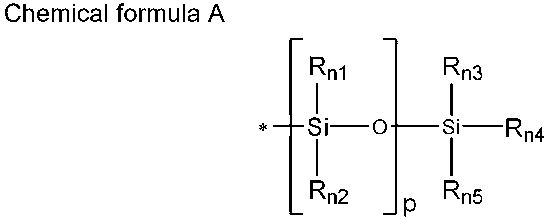 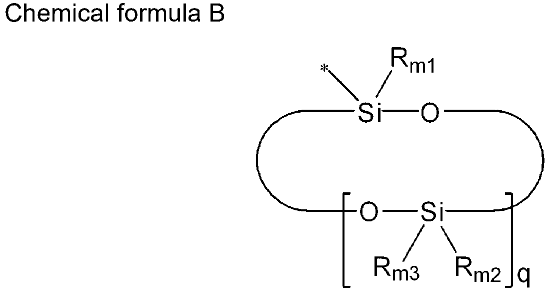
wherein, in chemical formulas A and B, Rₙ₁ to Rₙ₅ and Rₘ₁ to Rₘ₃ are each independently an alkoxy group having 1 to 20 carbon atoms, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, P is an integer from 1 to 20, and q is an integer from 1 to 5.

6. The display module of any one of the preceding claims, wherein the organic material comprises at least one selected from compounds of the following compound group 1:

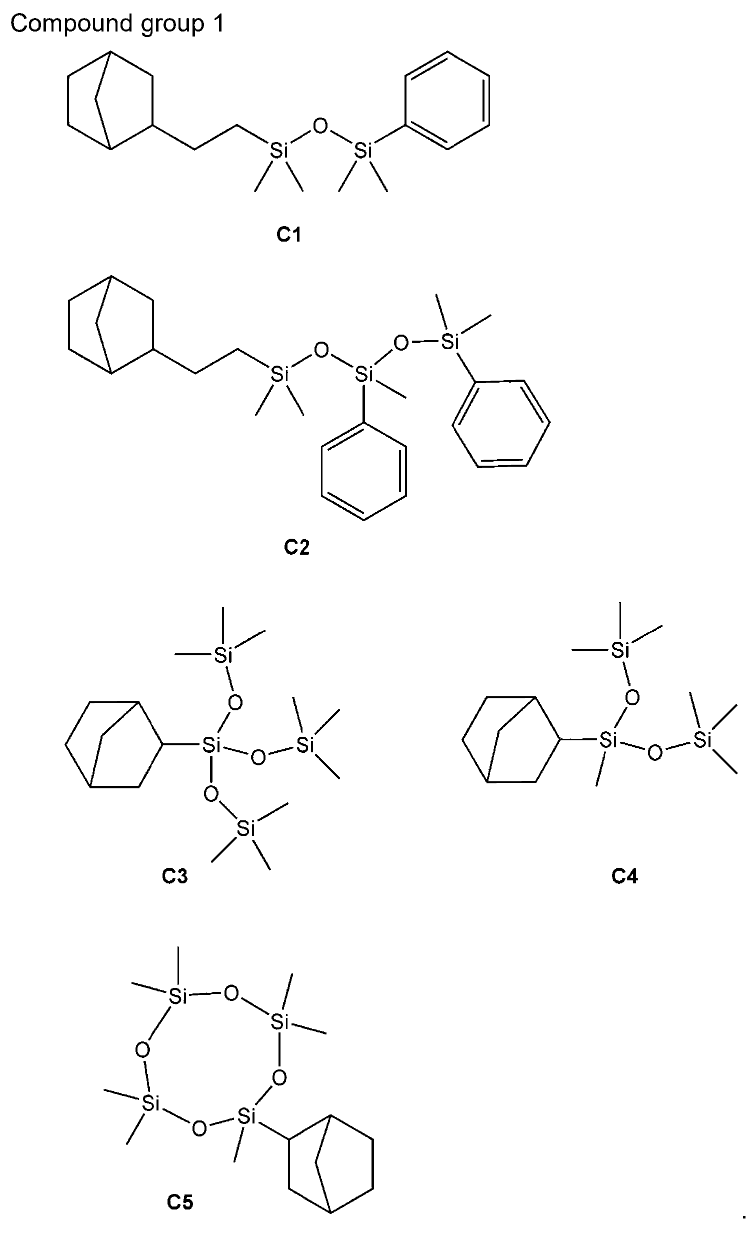

7. The display module of any one of the preceding claims, further comprising an input sensor on the encapsulation layer, wherein the encapsulation layer is directly on the light emitting element, and the input sensor is directly on the encapsulation layer; and/or
wherein the encapsulation layer covers the light emitting element.

8. The display module of any one of the preceding claims, wherein the light emitting element comprises:
a first electrode exposed through the pixel opening;
a second electrode on the first electrode; and
a light emitting layer between the first electrode and the second electrode.

9. The display module of claim 8, wherein the light emitting element further comprises:
a hole control layer between the first electrode and the light emitting layer;
and
an electron control layer between the light emitting layer and the second electrode.

10. The display module of any one of the preceding claims, wherein an upper surface of the second inorganic encapsulation layer defines an uppermost surface of the encapsulation layer.

11. An electronic device comprising:
a display module as defined in any one of the preceding claims, the display module further comprising a display panel and an input sensor on the display panel; and
a power module that supplies a power to the display module.

12. The electronic device of claim 11, wherein the input sensor comprises:
a first sensor insulating layer directly on the second inorganic encapsulation layer;
a first sensor conductive layer on the first sensor insulating layer;
a second sensor insulating layer on the first sensor insulating layer and covering the first sensor conductive layer; and
a second sensor conductive layer on the second sensor insulating layer.

13. A method of manufacturing a display module, comprising:
forming a display element layer comprising a pixel definition layer and a light emitting element; and
forming an encapsulation layer on the display element layer to cover the light emitting element, the forming of the encapsulation layer comprising:
forming a first inorganic encapsulation layer on the display element layer;
providing an encapsulation composition on the first inorganic encapsulation layer to form an organic encapsulation layer; and
forming a second inorganic encapsulation layer on the organic encapsulation layer, wherein the encapsulation composition is represented by any one selected from the following chemical formulas 1 to 3, 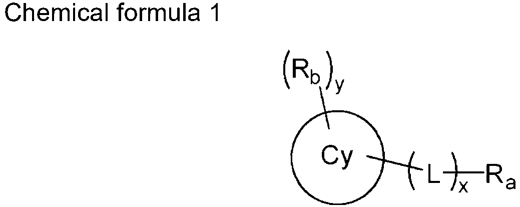 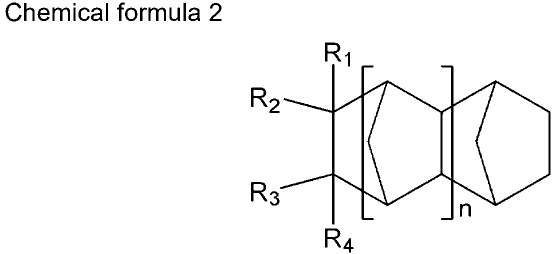 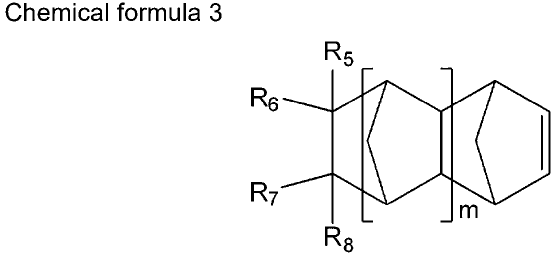
wherein, in chemical formulas 1 to 3, Cy is a norbornane ring or a norbornene ring, L is a direct linkage, a substituted or unsubstituted alkylene group having 1 to 20 carbon atoms, a substituted or unsubstituted alkyleneoxy group having 1 to 20 carbon atoms, or a substituted or unsubstituted aryleneoxy group having 6 to 30 ring-forming carbon atoms, Rₐ is a substituted or unsubstituted siloxane group, a substituted or unsubstituted cyclosiloxane group, a substituted or unsubstituted norbornane ring, a substituted or unsubstituted norbornene ring, or a substituted or unsubstituted alkyl group having 1 to 20 carbon atoms, or is bonded with a neighboring group to form a ring, R_{b} is a hydrogen atom, a deuterium atom, a halogen atom, a substituted or unsubstituted siloxane group, a substituted or unsubstituted cyclosiloxane group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or is bonded with a neighboring group to form a ring, x is an integer from 1 to 10, y is an integer from 1 to 11 if Cy is the norbornane ring, y is an integer from 0 to 9 if Cy is the norbornene ring, R₁ to R₈ are each independently a hydrogen atom, a deuterium atom, a halogen atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or are bonded with a neighboring group to form the ring, and n and m are each independently an integer from 0 to 20
wherein "substituted" means that hydrogen is substituted by a substituent selected from the group consisting of a deuterium atom, a halogen atom, a cyano group, a nitro group, an amine group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

14. The method of claim 13, wherein the encapsulation composition further comprises a photoinitiator and a crosslinker, and, based on 100 wt% of a total content of the encapsulation composition, the encapsulation composition comprises an organic material in an amount in a range from 60 wt% to 80 wt%, the photoinitiator in an amount in a range from 1 wt% to 10 wt%, and the crosslinker in an amount in a range from 20 wt% to 40 wt%.

15. The method of claim 13 or 14, wherein the forming of the organic encapsulation layer comprises:
coating the encapsulation composition on the first inorganic encapsulation layer to form a preliminary organic encapsulation layer; and
irradiating a light onto the preliminary organic encapsulation layer to form the organic encapsulation layer.
